# EUROPEAN PATENT APPLICATION

(11) **EP 4 456 700 A1**
(43) Date of publication of application: **30.10.2024**
(21) Application number: 23846924.1
(22) Date of filing: 21.07.2023
(51) Int. Cl.: H10K 85/60, H10K 50/17, H10K 50/16, H10K 50/11

(54) **ORGANIC LIGHT-EMITTING DEVICE**

(30) Priority: 27.07.2022 KR 20220093438
(71) Applicant: LG Chem, Ltd., Yeongdeungpo-gu Seoul 07336 (KR)
(72) Inventor: CHA, Yongbum, Daejeon 34122 (KR); GEUM, Sujeong, Daejeon 34122 (KR); KIM, Seonwoo, Daejeon 34122 (KR); CHO, Woo Jin, Daejeon 34122 (KR); CHOI, Ji Young, Daejeon 34122 (KR); HA, Jae Seung, Daejeon 34122 (KR); HWANG, Sunghyun, Daejeon 34122 (KR); LEE, Woochul, Daejeon 34122 (KR)
(74) Representative: Hoffmann Eitle
(86) International application number: PCT/KR2023/010576
(87) International publication number: WO 2024/025265

(57) **Abstract**

The present specification provides an organic light-emitting device comprising a compound represented by Chemical Formula 1 and a compound represented by Chemical Formula 2.

## Description

### [Technical Field]

The present application relates to an organic light emitting device.

This application claims priority to and the benefit of Korean Patent Application No. 10-2022-0093438 filed in the Korean Intellectual Property Office on July 27, 2022, the entire contents of which are incorporated herein by reference.

### [Background Art]

An organic light emission phenomenon generally refers to a phenomenon converting electrical energy to light energy using an organic material. An organic light emitting device using an organic light emission phenomenon normally has a structure including a positive electrode, a negative electrode, and an organic material layer therebetween. Here, the organic material layer has in many cases a multi-layered structure composed of different materials in order to improve the efficiency and stability of the organic light emitting device, and for example, may be composed of a hole injection layer, a hole transport layer, a light emitting layer, an electron transport layer, an electron injection layer, and the like. In such a structure of the organic light emitting device, if a voltage is applied between the two electrodes, holes are injected from the positive electrode into the organic material layer and electrons are injected from the negative electrode into the organic material layer, and when the injected holes and electrons meet each other, an exciton is formed, and light is emitted when the exciton falls down again to a ground state.

There is a continuous need for developing a new material for the aforementioned organic light emitting device.

### [Related Art Documents]

### [Patent Document]

(Patent Document 1) Korean Patent Application Laid-Open No. 10-2017-0036641

### [Detailed Description of the Invention]

### [Technical Problem]

The present application has been made in an effort to provide an organic light emitting device.

### [Technical Solution]

An exemplary embodiment of the present specification provides an organic light emitting device including: an anode; a cathode; and a first organic material layer and a second organic material layer provided between the anode and the cathode, in which the first organic material layer includes a compound of the following Chemical Formula 1 and the second organic material layer includes a compound of the following Chemical Formula 2.

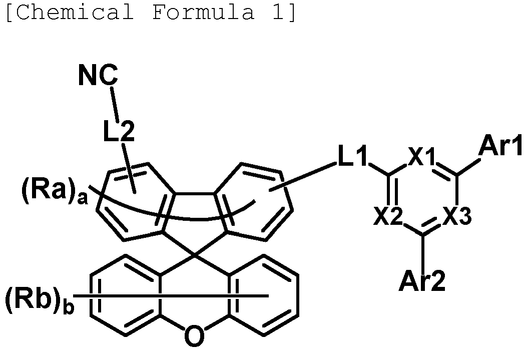

In Chemical Formula 1:
Ar1 and Ar2 are the same as or different from each other, and are each independently hydrogen, deuterium, or a substituted or unsubstituted aryl group;
L1 and L2 are the same as or different from each other, and are each independently a direct bond or a substituted or unsubstituted arylene group;
X1 to X3 are the same as or different from each other, and are each independently N or CR;
at least one of X1 to X3 is N;
Ra, Rb and R are the same as or different from each other, and are each independently hydrogen, deuterium, a substituted or unsubstituted alkyl group, or a substituted or unsubstituted aryl group;
a is an integer from 0 to 6, and when a is each 2 or higher, two or more Ras are the same as or different from each other, and
b is an integer from 0 to 8, and when b is 2 or higher, two or more Rbs are the same as or different from each other.

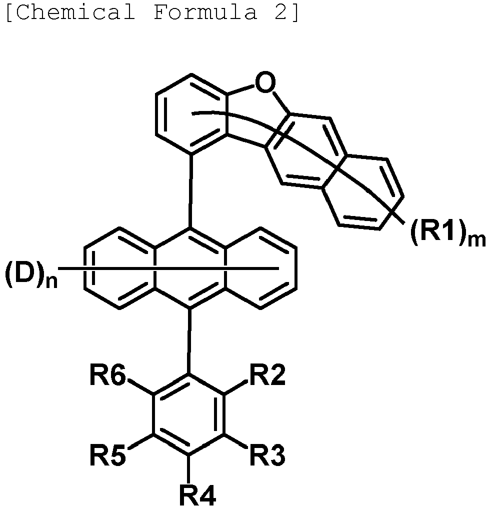

In Chemical Formula 2:
R1 is hydrogen, deuterium, a substituted or unsubstituted alkyl group, or a substituted or unsubstituted aryl group;
m is an integer from 0 to 9, and when m is 2 or higher, two or more R1s are the same as or different from each other;
D is deuterium, and n is an integer from 0 to 8;
R2 to R6 are the same as or different from each other, and are each independently hydrogen, deuterium, a substituted or unsubstituted alkyl group, or the following Chemical Formula A;
at least one of R2 and R6 is the following Chemical Formula A: 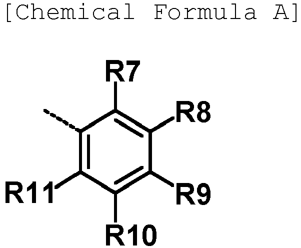 wherein in Chemical Formula A:
   R7 to R11 are the same as or different from each other, and are each independently hydrogen, deuterium, a substituted or unsubstituted alkyl group, or a substituted or unsubstituted aryl group, or adjacent substituents are bonded to each other to form a substituted or unsubstituted ring; and
   a dotted line (---) is a moiety linked to Chemical Formula 2.

### [Advantageous Effects]

The organic light emitting device described in the present specification has effects of low driving voltage, high efficiency and/or long service life by including a compound of Chemical Formula 1 in the first organic material layer and a compound of Chemical Formula 2 in the second organic material layer.

### [Brief Description of Drawings]

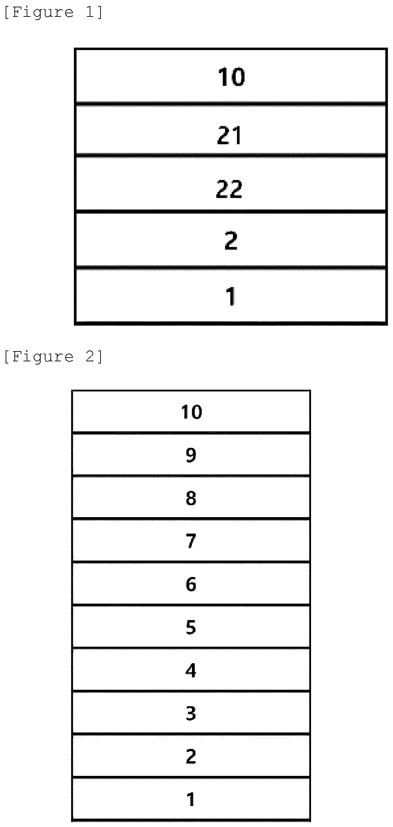

FIG. 1 illustrates an example of an organic light emitting device in which a substrate 1, an anode 2, a second organic material layer 22, a first organic material layer 21, and a cathode 10 are sequentially stacked.
FIG. 2 illustrates an example of an organic light emitting device in which a substrate 1, an anode 2, a hole injection layer 3, a hole transport layer 4, an electron blocking layer 5, a light emitting layer 6, a hole blocking layer 7, an electron transport layer 8, an electron injection layer 9, and a cathode 10 are sequentially stacked.

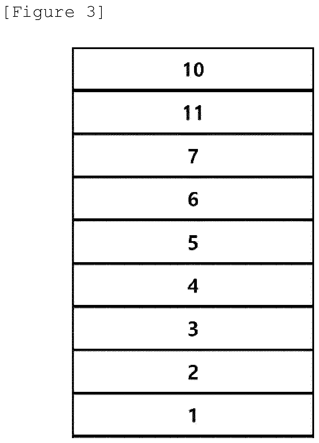

FIG. 3 illustrates an example of an organic light emitting device in which a substrate 1, an anode 2, a hole injection layer 3, a hole transport layer 4, an electron blocking layer 5, a light emitting layer 6, a hole blocking layer 7, an electron injection and transport layer 11, and a cathode 10 are sequentially stacked.

### [Detailed Description]

Hereinafter, the present specification will be described in more detail.

When one part "includes" one constituent element in the present specification, unless otherwise specifically described, this does not mean that another constituent element is excluded, but means that another constituent element may be further included.

When one member is disposed "on" another member in the present specification, this includes not only a case where the one member is brought into contact with another member, but also a case where still another member is present between the two members.

In the present specification, "dotted line (---)" means a position bonded to a chemical formula or a compound.

In the present specification, the deuterium substitution rate of a compound may be understood by a method of calculating the substitution rate based on the max. value of the distribution which molecular weights form at the end point of a reaction using thin-layer chromatography/mass spectrometry (TLC-MS) or a quantitative analysis method using NMR, and a method of adding DMF as an internal standard and calculating the D-substitution rate from the integrated amount of the total peak using the integration rate on 1H NMR.

In the present specification, "energy level" means a size of energy. Therefore, the energy level is interpreted to mean the absolute value of the corresponding energy value. For example, a low or deep energy level means that the absolute value increases in the negative direction from the vacuum level.

In the present specification, the highest occupied molecular orbital (HOMO) means a molecular orbital (highest occupied molecular orbital) in the highest energy region in regions in which electrons can participate in bonding, the lowest unoccupied molecular orbital (LUMO) means the molecular orbital (lowest unoccupied molecular orbital) in which electrons are present in the lowest energy region among the semi-bonded regions, and the HOMO energy level means the distance from the vacuum level to the HOMO. Furthermore, the LUMO energy level means the distance from the vacuum level to the LUMO.

In the present specification, a bandgap means a difference in energy level between HOMO and LUMO, that is, a HOMO-LUMO gap (Gap).

In the present specification, the HOMO energy level may be measured using a photoelectron spectrometer under the atmosphere (manufactured by RIKEN KEIKI Co., Ltd.: AC3), and the LUMO energy level may be calculated from wavelength values measured through photoluminescence (PL).

Examples of the substituents in the present specification will be described below, but are not limited thereto.

The term "substitution" means that a hydrogen atom bonded to a carbon atom of a compound is changed into another substituent, and a position to be substituted is not limited as long as the position is a position at which the hydrogen atom is substituted, that is, a position at which the substituent may be substituted, and when two or more are substituted, the two or more substituents may be the same as or different from each other.

In the present specification, the term "substituted or unsubstituted" means being substituted with one or two or more substituents selected from the group consisting of deuterium, a halogen group, a cyano group, an alkyl group, a cycloalkyl group, an aryl group, and a heterocyclic group, being substituted with a substituent to which two or more substituents among the exemplified substituents are linked together, or having no substituent.

In the present specification, the term "substituted or unsubstituted" means being substituted with one or two or more substituents selected from the group consisting of deuterium, an alkyl group, an aryl group, and a heterocyclic group, being substituted with a substituent to which two or more substituents among the exemplified substituents are linked together, or having no substituent.

Examples of the substituents will be described below, but are not limited thereto.

In the present specification, examples of a halogen group include fluorine (-F), chlorine (-Cl), bromine (-Br) or iodine (-I).

In the present specification, the alkyl group may be straight-chained or branched, and the number of carbon atoms thereof is not particularly limited, but is preferably 1 to 60. According to an exemplary embodiment, the number of carbon atoms of the alkyl group is 1 to 30. According to another exemplary embodiment, the number of carbon atoms of the alkyl group is 1 to 20. According to still another exemplary embodiment, the number of carbon atoms of the alkyl group is 1 to 10. Specific examples of the alkyl group include a methyl group, an ethyl group, a propyl group, an n-propyl group, an isopropyl group, a butyl group, an n-butyl group, an isobutyl group, a tert-butyl group, a pentyl group, an n-pentyl group, a hexyl group, an n-hexyl group, a heptyl group, an n-heptyl group, an octyl group, an n-octyl group, and the like, but are not limited thereto.

In the present specification, a cycloalkyl group is not particularly limited, but has preferably 3 to 60 carbon atoms, and according to an exemplary embodiment, the number of carbon atoms of the cycloalkyl group is 3 to 30. According to another exemplary embodiment, the number of carbon atoms of the cycloalkyl group is 3 to 20. According to still another exemplary embodiment, the number of carbon atoms of the cycloalkyl group is 3 to 6. Specific examples thereof include a cyclopropyl group, a cyclobutyl group, a cyclopentyl group, a cyclohexyl group, a cycloheptyl group, a cyclooctyl group, and the like, but are not limited thereto.

In the present specification, an aryl group is not particularly limited, but has preferably 6 to 60 carbon atoms, and may be a monocyclic aryl group or a polycyclic aryl group. According to an exemplary embodiment, the number of carbon atoms of the aryl group is 6 to 30. According to an exemplary embodiment, the number of carbon atoms of the aryl group is 6 to 20. Examples of the monocyclic aryl group include a phenyl group, a biphenyl group, a terphenyl group, a quarterphenyl group, and the like, but are not limited thereto. Examples of the polycyclic aryl group include a naphthyl group, an anthracenyl group, a phenanthrenyl group, a pyrenyl group, a perylenyl group, a chrysenyl group, a fluorenyl group, a triphenylenyl group, and the like, but are not limited thereto.

In the present specification, a fluorenyl group may be substituted, and two substituents may be bonded to each other to form a spiro structure.

When the fluorenyl group is substituted, the substituent may be a spirofluorenyl group such as 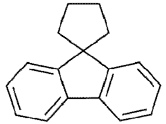 and 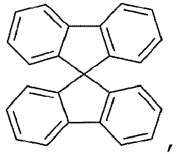 and a substituted fluorenyl group such as 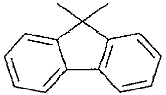 (a 9,9-dimethylfluorenyl group) and 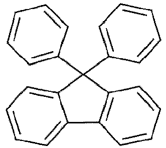 (a 9, 9-diphenylfluorenyl group). However, the substituent is not limited thereto.

In the present specification, a heterocyclic group is a cyclic group including one or more of N, O, P, S, Si, and Se as a heteroatom, and the number of carbon atoms thereof is not particularly limited, but is preferably 2 to 60. According to an exemplary embodiment, the number of carbon atoms of the heterocyclic group is 2 to 30. According to an exemplary embodiment, the number of carbon atoms of the heterocyclic group is 2 to 20. Examples of the heterocyclic group include a pyridine group, a pyrrole group, a pyrimidine group, a quinoline group, a pyridazinyl group, a furan group, a thiophene group, an imidazole group, a pyrazole group, a dibenzofuran group, a dibenzothiophene group, a carbazole group, a benzocarbazole group, a naphthobenzofuran group, a benzonaphthothiophene group, an indenocarbazole group, a triazinyl group, and the like, but are not limited thereto.

In the present specification, the above-described description of the heterocyclic group may be applied to a heteroaryl group except for an aromatic heteroaryl group.

In the present specification, the description of the aryl group may be applied to the arylene group except for a divalent group, and for example, a phenylene group, a naphthylene group, a biphenylene group, a fluorenylene group, a phenanthrylene group, a terphenylene group, an anthracenylene group, a pyrenylene group, and the like are exemplified.

In the present specification, the description of the heterocyclic group may be applied to a divalent heterocyclic group except for a divalent heterocyclic group.

In the present specification, the description of the aryl group may be applied to a (n+1)-valent aryl group except for a (n+1)-valent aryl group.

In the present specification, the description of the heterocyclic group may be applied to a (n+1)-valent heterocyclic group except for a (n+1)-valent heterocyclic group.

In the present specification, in a substituted or unsubstituted ring formed by being bonded to an adjacent group, the "ring" means a hydrocarbon ring; or a hetero ring.

The hydrocarbon ring may be an aromatic ring, an aliphatic ring, or a fused ring of the aromatic ring and the aliphatic ring, and may be selected from the examples of the cycloalkyl group or the aryl group.

In the present specification, being bonded to an adjacent group to form a ring means being bonded to an adjacent group to form a substituted or unsubstituted aliphatic hydrocarbon ring, a substituted or unsubstituted aromatic hydrocarbon ring, a substituted or unsubstituted aliphatic hetero ring, a substituted or unsubstituted aromatic hetero ring, or a fused ring thereof. The hydrocarbon ring means a ring composed only of carbon and hydrogen atoms. The hetero ring means a ring including one or more selected from among N, O, P, S, Si and Se. In the present specification, the aliphatic hydrocarbon ring, the aromatic hydrocarbon ring, the aliphatic hetero ring, and the aromatic hetero ring may be monocyclic or polycyclic.

In the present specification, the aliphatic hydrocarbon ring means a ring composed only of carbon and hydrogen atoms as a non-aromatic ring. Examples of the aliphatic hydrocarbon ring include cyclopropane, cyclobutane, cyclobutene, cyclopentane, cyclopentene, cyclohexane, cyclohexene, 1,4-cyclohexadiene, cycloheptane, cycloheptene, cyclooctane, cyclooctene, and the like, but are not limited thereto.

In the present specification, an aromatic hydrocarbon ring means an aromatic ring composed only of carbon and hydrogen atoms. Examples of the aromatic hydrocarbon ring include benzene, naphthalene, anthracene, phenanthrene, perylene, fluoranthene, triphenylene, phenalene, pyrene, tetracene, chrysene, pentacene, fluorene, indene, acenaphthylene, benzofluorene, spirofluorene, and the like, but are not limited thereto. In the present specification, the aromatic hydrocarbon ring may be interpreted to have the same meaning as the aryl group.

In the present specification, an aliphatic hetero ring means an aliphatic ring including one or more of hetero atoms. Examples of the aliphatic hetero ring include oxirane, tetrahydrofuran, 1,4-dioxane, pyrrolidine, piperidine, morpholine, oxepane, azocane, thiocane, and the like, but are not limited thereto.

In the present specification, an aromatic hetero ring means an aromatic ring including one or more of hetero atoms. Examples of the aromatic hetero ring include pyridine, pyrrole, pyrimidine, pyridazine, furan, thiophene, imidazole, pyrazole, oxazole, isoxazole, thiazole, isothiazole, triazole, oxadiazole, thiadiazole, dithiazole, tetrazole, pyran, thiopyran, diazine, oxazine, thiazine, dioxine, triazine, tetrazine, isoquinoline, quinoline, quinone, quinazoline, quinoxaline, naphthyridine, acridine, phenanthridine, diaza naphthalene, triazaindene, indole, indolizine, benzothiazole, benzoxazole, benzoimidazole, benzothiophene, benzofuran, dibenzothiophene, dibenzofuran, carbazole, benzocarbazole, dibenzocarbazole, phenazine, imidazopyridine, phenoxazine, indolocarbazole, indenocarbazole, and the like, but are not limited thereto.

Hereinafter, preferred exemplary embodiments of the present invention will be described in detail. However, the exemplary embodiments of the present invention may be modified into various other forms, and the scope of the present invention is not limited to the exemplary embodiments which will be described below.

The organic light emitting device of the present invention is characterized by including both the compound of Chemical Formula 1 and the compound of Chemical Formula 2, and the organic light emitting device of the present invention exhibits the effects of low voltage, high efficiency and/or long service life.

Hereinafter, Chemical Formula 1 will be described in detail.

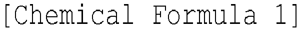

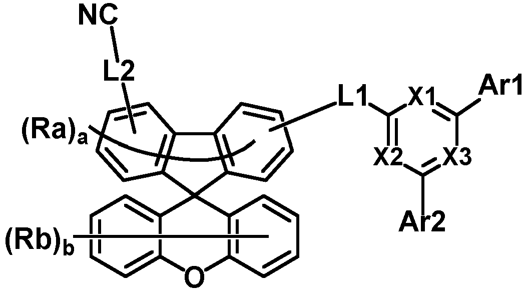

In Chemical Formula 1:
Ar1 and Ar2 are the same as or different from each other, and are each independently hydrogen, deuterium, or a substituted or unsubstituted aryl group;
L1 and L2 are the same as or different from each other, and are each independently a direct bond or a substituted or unsubstituted arylene group;
X1 to X3 are the same as or different from each other, and are each independently N or CR;
at least one of X1 to X3 is N;
Ra, Rb and R are the same as or different from each other, and are each independently hydrogen, deuterium, a substituted or unsubstituted alkyl group, or a substituted or unsubstituted aryl group;
a is an integer from 0 to 6, and when a is each 2 or higher, two or more Ras are the same as or different from each other; and
b is an integer from 0 to 8, when b is 2 or higher, two or more Rbs are the same as or different from each other.

In an exemplary embodiment of the present specification, Ar1 and Ar2 are the same as or different from each other, and are each independently hydrogen, deuterium, or a substituted or unsubstituted aryl group having 6 to 60 carbon atoms.

In an exemplary embodiment of the present specification, Ar1 and Ar2 are the same as or different from each other, and are each independently hydrogen, deuterium, or a substituted or unsubstituted aryl group having 6 to 30 carbon atoms.

In an exemplary embodiment of the present specification, Ar1 and Ar2 are the same as or different from each other, and are each independently hydrogen, deuterium, or a substituted or unsubstituted aryl group having 6 to 20 carbon atoms.

In an exemplary embodiment of the present specification, Ar1 and Ar2 are the same as or different from each other, and are each independently hydrogen, deuterium, or an aryl group which is unsubstituted or substituted with deuterium.

In an exemplary embodiment of the present specification, Ar1 and Ar2 are the same as or different from each other, and are each independently hydrogen, deuterium, or an aryl group having 6 to 60 carbon atoms, which is unsubstituted or substituted with deuterium.

In an exemplary embodiment of the present specification, Ar1 and Ar2 are the same as or different from each other, and are each independently hydrogen, deuterium, or an aryl group having 6 to 30 carbon atoms, which is unsubstituted or substituted with deuterium.

In an exemplary embodiment of the present specification, Ar1 and Ar2 are the same as or different from each other, and are each independently hydrogen, deuterium, or an aryl group having 6 to 20 carbon atoms, which is unsubstituted or substituted with deuterium.

In an exemplary embodiment of the present specification, Ar1 and Ar2 are the same as or different from each other, and are each independently a substituted or unsubstituted aryl group.

In an exemplary embodiment of the present specification, Ar1 and Ar2 are the same as or different from each other, and are each independently a substituted or unsubstituted aryl group having 6 to 60 carbon atoms.

In an exemplary embodiment of the present specification, Ar1 and Ar2 are the same as or different from each other, and are each independently a substituted or unsubstituted aryl group having 6 to 30 carbon atoms.

In an exemplary embodiment of the present specification, Ar1 and Ar2 are the same as or different from each other, and are each independently a substituted or unsubstituted aryl group having 6 to 20 carbon atoms.

In an exemplary embodiment of the present specification, Ar1 and Ar2 are the same as or different from each other, and are each independently hydrogen, deuterium, a substituted or unsubstituted phenyl group, a substituted or unsubstituted biphenyl group, a substituted or unsubstituted terphenyl group, a substituted or unsubstituted naphthyl group, a substituted or unsubstituted phenanthrenyl group, or a substituted or unsubstituted fluorenyl group.

In an exemplary embodiment of the present specification, Ar1 and Ar2 are the same as or different from each other, and are each independently hydrogen, deuterium, a substituted or unsubstituted phenyl group, a substituted or unsubstituted biphenyl group, a substituted or unsubstituted terphenyl group, or a substituted or unsubstituted naphthyl group.

In an exemplary embodiment of the present specification, Ar1 and Ar2 are the same as or different from each other, and are each independently hydrogen, deuterium, a substituted or unsubstituted phenyl group, a substituted or unsubstituted biphenyl group, or a substituted or unsubstituted naphthyl group.

In an exemplary embodiment of the present specification, Ar1 and Ar2 are the same as or different from each other, and are each independently a phenyl group which is unsubstituted or substituted with deuterium; a biphenyl group which is unsubstituted or substituted with deuterium; or a naphthyl group which is unsubstituted or substituted with deuterium.

In an exemplary embodiment of the present specification, Ar1 and Ar2 are the same as or different from each other, and are each independently a substituted or unsubstituted phenyl group, a substituted or unsubstituted biphenyl group, a substituted or unsubstituted terphenyl group, a substituted or unsubstituted naphthyl group, a substituted or unsubstituted phenanthrenyl group, or a substituted or unsubstituted fluorenyl group, and at least one of Ar1 and Ar2 is a substituted or unsubstituted phenyl group.

In an exemplary embodiment of the present specification, Ar1 and Ar2 are the same as or different from each other, and are each independently a substituted or unsubstituted phenyl group, a substituted or unsubstituted biphenyl group, or a substituted or unsubstituted naphthyl group, and at least one of Ar1 and Ar2 is a substituted or unsubstituted phenyl group.

In an exemplary embodiment of the present specification, Ar1 and Ar2 are the same as or different from each other, and are each independently a phenyl group, which is unsubstituted or substituted with deuterium; a biphenyl group, which is unsubstituted or substituted with deuterium; a terphenyl group, which is unsubstituted or substituted with deuterium; a naphthyl group, which is unsubstituted or substituted with deuterium; a phenanthrenyl group, which is unsubstituted or substituted with deuterium; or a fluorenyl group, which is unsubstituted or substituted with deuterium, and at least one of Ar1 and Ar2 is a phenyl group, which is unsubstituted or substituted with deuterium.

In an exemplary embodiment of the present specification, Ar1 and Ar2 are the same as or different from each other, and are each independently a phenyl group which is unsubstituted or substituted with deuterium; a biphenyl group which is unsubstituted or substituted with deuterium; or a naphthyl group which is unsubstituted or substituted with deuterium, and at least one of Ar1 and Ar2 is a phenyl group which is unsubstituted or substituted with deuterium.

In an exemplary embodiment of the present specification, Ar1 and Ar2 are the same as or different from each other, and are each independently a phenyl group, a biphenyl group, or a naphthyl group, and at least one of Ar1 and Ar2 is a phenyl group.

In an exemplary embodiment of the present specification, L1 and L2 are the same as or different from each other, and are each independently a direct bond or a substituted or unsubstituted arylene group.

In an exemplary embodiment of the present specification, L1 and L2 are the same as or different from each other, and are each independently a direct bond or a substituted or unsubstituted arylene group having 6 to 60 carbon atoms.

In an exemplary embodiment of the present specification, L1 and L2 are the same as or different from each other, and are each independently a direct bond or a substituted or unsubstituted arylene group having 6 to 30 carbon atoms.

In an exemplary embodiment of the present specification, L1 and L2 are the same as or different from each other, and are each independently a direct bond or a substituted or unsubstituted arylene group having 6 to 20 carbon atoms.

In an exemplary embodiment of the present specification, L1 and L2 are the same as or different from each other, and are each independently a direct bond, a substituted or unsubstituted phenylene group, a substituted or unsubstituted biphenylene group, a substituted or unsubstituted terphenylene group, or a substituted or unsubstituted naphthylene group.

In an exemplary embodiment of the present specification, L1 and L2 are the same as or different from each other, and are each independently a direct bond, a substituted or unsubstituted phenylene group, a substituted or unsubstituted biphenylene group, or a substituted or unsubstituted naphthylene group.

In an exemplary embodiment of the present specification, L1 and L2 are the same as or different from each other, and are each independently a direct bond, a substituted or unsubstituted phenylene group, or a substituted or unsubstituted biphenylene group.

In an exemplary embodiment of the present specification, L1 and L2 are the same as or different from each other, and are each independently a direct bond; a phenylene group which is unsubstituted or substituted with deuterium; or a biphenylene group which is unsubstituted or substituted with deuterium.

In an exemplary embodiment of the present specification, L1 and L2 are the same as or different from each other, and are each independently a direct bond, a phenylene group, or a biphenylene group.

In an exemplary embodiment of the present specification, L1 is a direct bond, a substituted or unsubstituted phenylene group, a substituted or unsubstituted biphenylene group, a substituted or unsubstituted terphenylene group, or a substituted or unsubstituted naphthylene group.

In an exemplary embodiment of the present specification, L1 is a substituted or unsubstituted phenylene group, or a substituted or unsubstituted biphenylene group.

In an exemplary embodiment of the present specification, L1 is a direct bond; a phenylene group which is unsubstituted or substituted with deuterium; a biphenylene group which is unsubstituted or substituted with deuterium; a terphenylene group which is unsubstituted or substituted with deuterium; or a naphthylene group which is unsubstituted or substituted with deuterium.

In an exemplary embodiment of the present specification, L1 is a phenylene group which is unsubstituted or substituted with deuterium; or a biphenylene group which is unsubstituted or substituted with deuterium.

In an exemplary embodiment of the present specification, L1 is a phenylene group or a biphenylene group.

In an exemplary embodiment of the present specification, L2 is a direct bond or a substituted or unsubstituted phenylene group.

In an exemplary embodiment of the present specification, L2 is a substituted or unsubstituted phenylene group.

In an exemplary embodiment of the present specification, L2 is a direct bond or a phenylene group which is unsubstituted or substituted with deuterium.

In an exemplary embodiment of the present specification, L2 is a phenylene group which is unsubstituted or substituted with deuterium.

In an exemplary embodiment of the present specification, L2 is a phenylene group.

In an exemplary embodiment of the present specification, at least one of X1 to X3 is N.

In an exemplary embodiment of the present specification, one of X1 to X3 is N.

In an exemplary embodiment of the present specification, two of X1 to X3 are N.

In an exemplary embodiment of the present specification, X1 to X3 are N.

In an exemplary embodiment of the present specification, X1 is N, and X2 and X3 are CR.

In an exemplary embodiment of the present specification, X2 is N, and X1 and X3 are CR.

In an exemplary embodiment of the present specification, X3 is N, and X1 and X2 are CR.

In an exemplary embodiment of the present specification, X1 and X2 are N, and X3 is CR.

In an exemplary embodiment of the present specification, X1 and X3 are N, and X2 is CR.

In an exemplary embodiment of the present specification, X2 and X3 are N, and X1 is CR.

In an exemplary embodiment of the present specification, Ra, Rb and R are the same as or different from each other, and are each independently hydrogen, deuterium, a substituted or unsubstituted alkyl group having 1 to 60 carbon atoms, or a substituted or unsubstituted aryl group having 6 to 60 carbon atoms.

In an exemplary embodiment of the present specification, Ra, Rb and R are the same as or different from each other, and are each independently hydrogen, deuterium, a substituted or unsubstituted alkyl group having 1 to 30 carbon atoms, or a substituted or unsubstituted aryl group having 6 to 30 carbon atoms.

In an exemplary embodiment of the present specification, Ra, Rb and R are the same as or different from each other, and are each independently hydrogen, deuterium, a substituted or unsubstituted alkyl group having 1 to 20 carbon atoms, or a substituted or unsubstituted aryl group having 6 to 20 carbon atoms.

In an exemplary embodiment of the present specification, Ra, Rb and R are the same as or different from each other, and are each independently hydrogen; deuterium; an alkyl group which is unsubstituted or substituted with deuterium; or an aryl group which is unsubstituted or substituted with deuterium.

In an exemplary embodiment of the present specification, Ra, Rb and R are the same as or different from each other, and are each independently hydrogen; deuterium; an alkyl group having 1 to 60 carbon atoms, which is unsubstituted or substituted with deuterium; or an aryl group having 6 to 60 carbon atoms, which is unsubstituted or substituted with deuterium.

In an exemplary embodiment of the present specification, Ra, Rb and R are the same as or different from each other, and are each independently hydrogen; deuterium; an alkyl group having 1 to 30 carbon atoms, which is unsubstituted or substituted with deuterium; or an aryl group having 6 to 30 carbon atoms, which is unsubstituted or substituted with deuterium.

In an exemplary embodiment of the present specification, Ra, Rb and R are the same as or different from each other, and are each independently hydrogen; deuterium; an alkyl group having 1 to 20 carbon atoms, which is unsubstituted or substituted with deuterium; or an aryl group having 6 to 20 carbon atoms, which is unsubstituted or substituted with deuterium.

In an exemplary embodiment of the present specification, Ra, Rb and R are the same as or different from each other, and are each independently hydrogen; deuterium; an alkyl group having 1 to 10 carbon atoms, which is unsubstituted or substituted with deuterium; or an aryl group having 6 to 20 carbon atoms, which is unsubstituted or substituted with deuterium.

In an exemplary embodiment of the present specification, Ra, Rb and R are the same as or different from each other, and are each independently hydrogen or deuterium.

In an exemplary embodiment of the present specification, Ra, Rb and R are all hydrogen.

In an exemplary embodiment of the present specification, Ra, Rb and R are all deuterium.

In an exemplary embodiment of the present specification, a is an integer from 0 to 6, and when a is each 2 or higher, two or more Ras are the same as or different from each other.

In an exemplary embodiment of the present specification, a is an integer from 0 to 6.

In an exemplary embodiment of the present specification, a is an integer from 1 to 6.

In an exemplary embodiment of the present specification, a is 6.

In an exemplary embodiment of the present specification, a is 5.

In an exemplary embodiment of the present specification, a is 4.

In an exemplary embodiment of the present specification, a is 3.

In an exemplary embodiment of the present specification, a is 2.

In an exemplary embodiment of the present specification, a is 1.

In an exemplary embodiment of the present specification, a is 0.

In an exemplary embodiment of the present specification, b is an integer from 0 to 8, and when b is 2 or higher, two or more Rbs are the same as or different from each other.

In an exemplary embodiment of the present specification, b is an integer from 0 to 8.

In an exemplary embodiment of the present specification, b is an integer from 1 to 8.

In an exemplary embodiment of the present specification, b is 8.

In an exemplary embodiment of the present specification, b is 7.

In an exemplary embodiment of the present specification, b is 6.

In an exemplary embodiment of the present specification, b is 5.

In an exemplary embodiment of the present specification, b is 4.

In an exemplary embodiment of the present specification, b is 3.

In an exemplary embodiment of the present specification, b is 2.

In an exemplary embodiment of the present specification, b is 1.

In an exemplary embodiment of the present specification, b is 0.

In an exemplary embodiment of the present specification, Chemical Formula 1 is any one of the following Chemical Formulae 1-1 to 1-4.

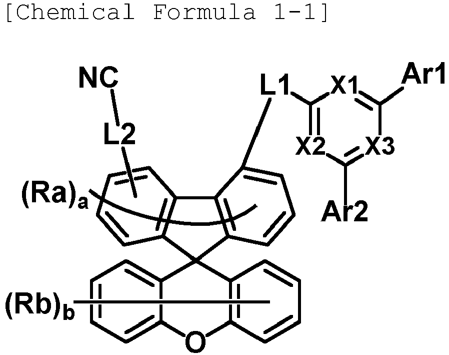

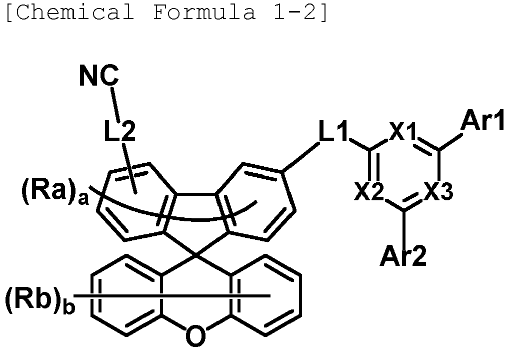

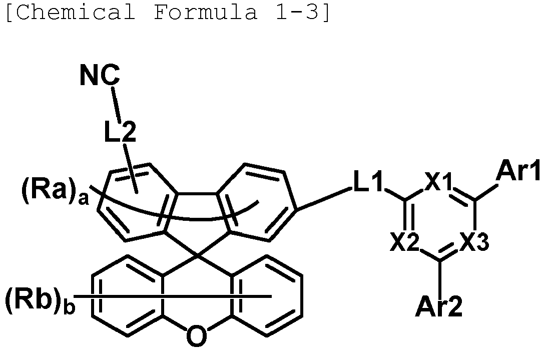

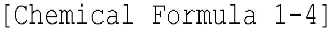

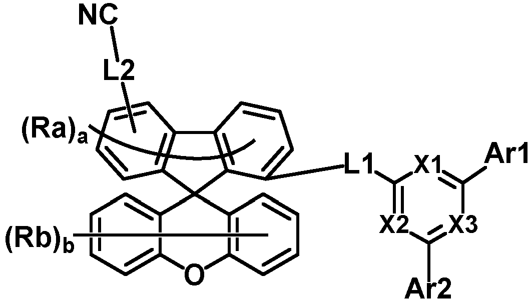

In Chemical Formulae 1-1 to 1-4,
the definitions of Ar1, Ar2, L1, L2, X1 to X3, Ra, Rb, a and b are the same as the definitions in Chemical Formula 1.

In an exemplary embodiment of the present specification, Chemical Formula 1 is any one of the following Chemical Formulae 1-A to 1-D.

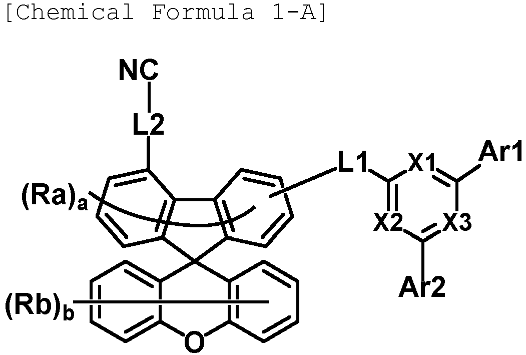

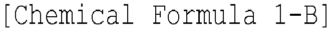

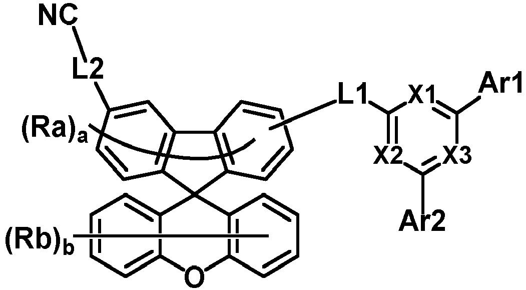

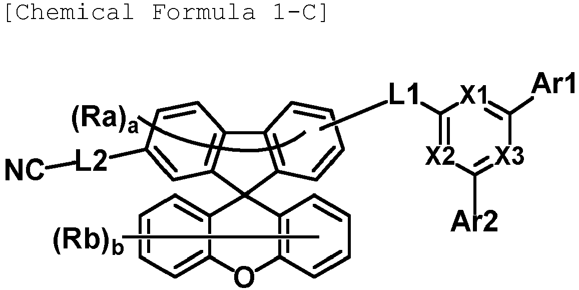

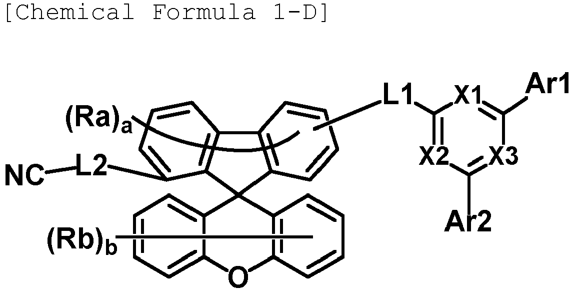

In Chemical Formulae 1-A to 1-D,
the definitions of Ar1, Ar2, L1, L2, X1 to X3, Ra, Rb, a and b are the same as the definitions in Chemical Formula 1.

In an exemplary embodiment of the present specification, Chemical Formula 1 is the following Chemical Formula 1-1-1.

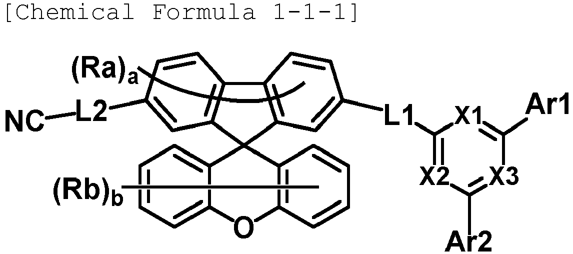

In Chemical Formula 1-1-1,
the definitions of Ar1, Ar2, L1, L2, X1 to X3, Ra, Rb, a and b are the same as the definitions in Chemical Formula 1.

In an exemplary embodiment of the present specification, at least 40% of the compound of Chemical Formula 1 is substituted with deuterium. In another exemplary embodiment, 50% or more of the compound of Chemical Formula 1 is substituted with deuterium. In still another exemplary embodiment, 60% or more of the compound of Chemical Formula 1 is substituted with deuterium. In yet another exemplary embodiment, 70% or more of the compound of Chemical Formula 1 is substituted with deuterium. In still yet another exemplary embodiment, 80% or more of the compound of Chemical Formula 1 is substituted with deuterium. In a further exemplary embodiment, 90% or more of the compound of Chemical Formula 1 is substituted with deuterium. In another further exemplary embodiment, 100% of the compound of Chemical Formula 1 is substituted with deuterium.

In an exemplary embodiment of the present specification, the compound of Chemical Formula 1 includes 40% to 60% of deuterium. In another exemplary embodiment, the compound of Chemical Formula 1 includes 40% to 80% of deuterium. In still another exemplary embodiment, the compound of Chemical Formula 1 includes 60% to 80% of deuterium. In yet another exemplary embodiment, the compound of Chemical Formula 1 includes 80% to 100% of deuterium.

In an exemplary embodiment of the present specification, the compound of Chemical Formula 1 is any one of the following compounds.
of the following compounds:

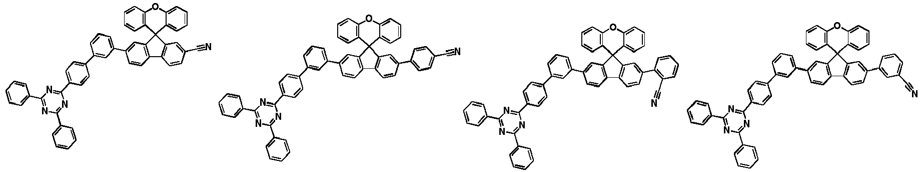

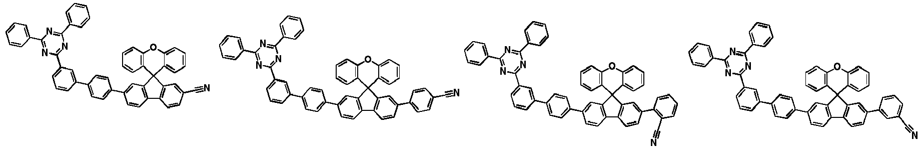

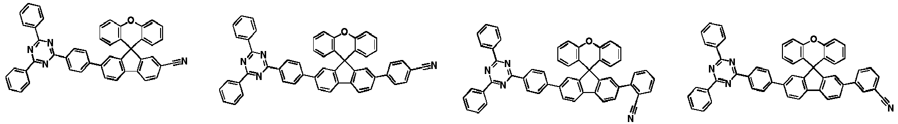

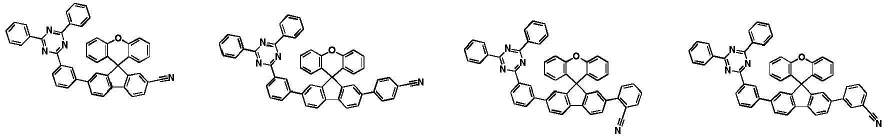

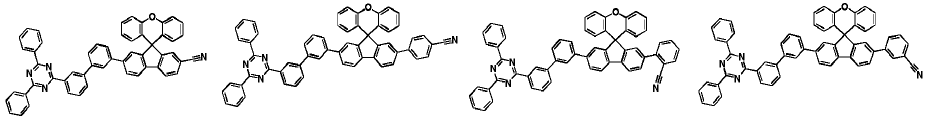

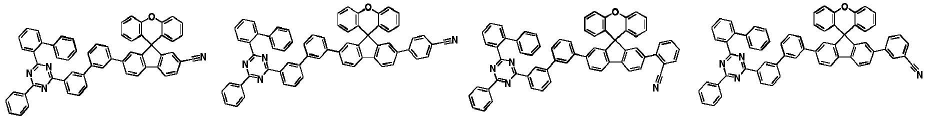

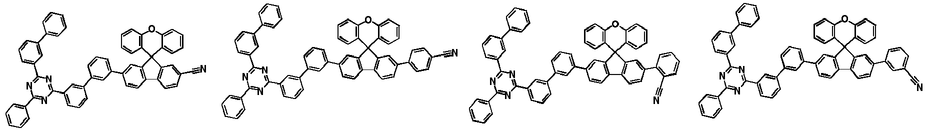

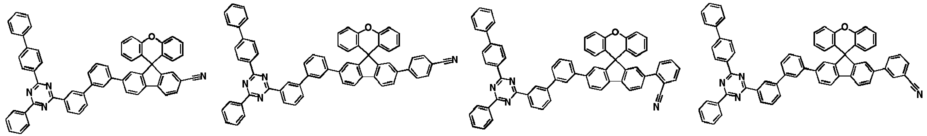

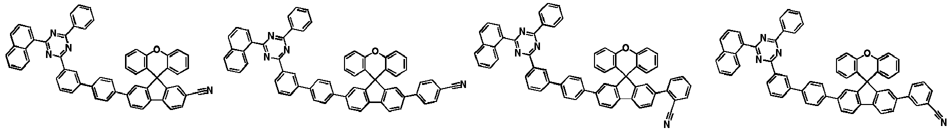

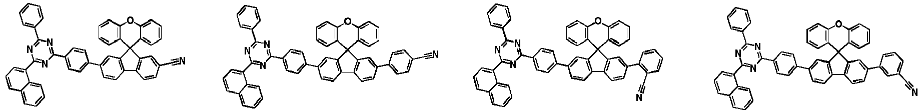

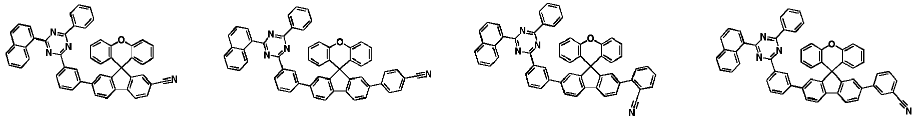

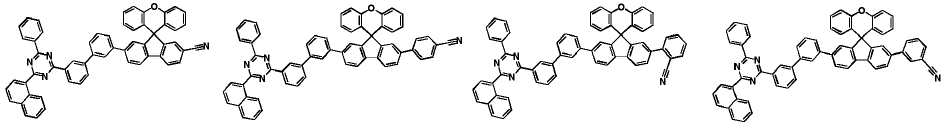

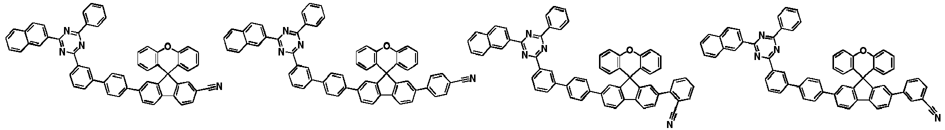

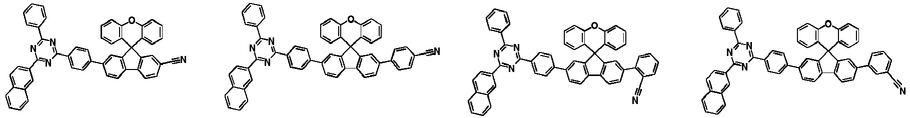

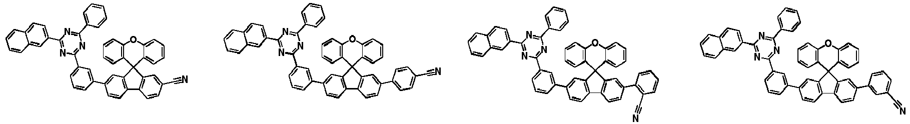

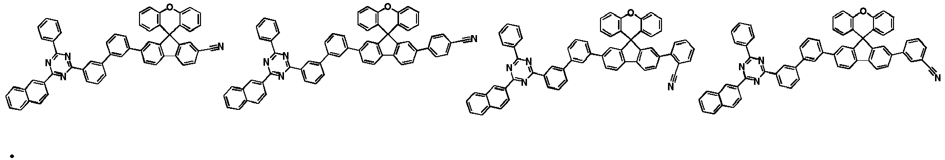

Hereinafter, Chemical Formula 2 will be described in detail.

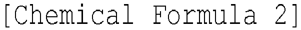

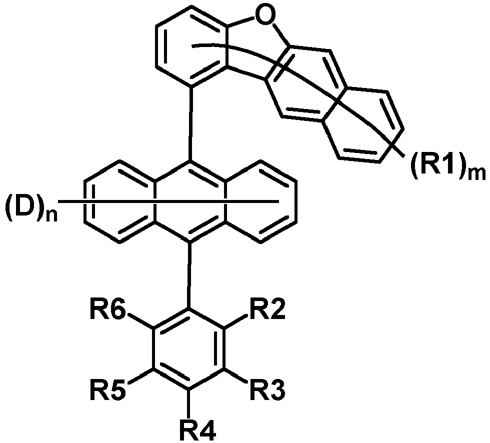

In Chemical Formula 2:
R1 is hydrogen, deuterium, a substituted or unsubstituted alkyl group, or a substituted or unsubstituted aryl group;
m is an integer from 0 to 9, and when m is 2 or higher, two or more R1s are the same as or different from each other;
D is deuterium, and n is an integer from 0 to 8;
R2 to R6 are the same as or different from each other, and are each independently hydrogen, deuterium, a substituted or unsubstituted alkyl group, or the following Chemical Formula A; and
at least one of R2 and R6 is the following Chemical Formula A: 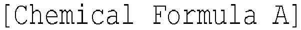 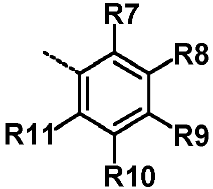
wherein in Chemical Formula A:
R7 to R11 are the same as or different from each other, and are each independently hydrogen, deuterium, a substituted or unsubstituted alkyl group, or a substituted or unsubstituted aryl group, or adjacent substituents are bonded to each other to form a substituted or unsubstituted ring; and
a dotted line (---) is a moiety linked to Chemical Formula 2.

In an exemplary embodiment of the present specification, R1 is hydrogen, deuterium, a substituted or unsubstituted alkyl group having 1 to 60 carbon atoms, or a substituted or unsubstituted aryl group having 6 to 60 carbon atoms.

In an exemplary embodiment of the present specification, R1 is hydrogen, deuterium, a substituted or unsubstituted alkyl group having 1 to 30 carbon atoms, or a substituted or unsubstituted aryl group having 6 to 30 carbon atoms.

In an exemplary embodiment of the present specification, R1 is hydrogen, deuterium, a substituted or unsubstituted alkyl group having 1 to 20 carbon atoms, or a substituted or unsubstituted aryl group having 6 to 20 carbon atoms.

In an exemplary embodiment of the present specification, R1 is hydrogen, deuterium, an alkyl group which is unsubstituted or substituted with deuterium, or an aryl group which is unsubstituted or substituted with deuterium.

In an exemplary embodiment of the present specification, R1 is hydrogen; deuterium; an alkyl group having 1 to 60 carbon atoms, which is unsubstituted or substituted with deuterium; or an aryl group having 6 to 60 carbon atoms, which is unsubstituted or substituted with deuterium.

In an exemplary embodiment of the present specification, R1 is hydrogen; deuterium; an alkyl group having 1 to 30 carbon atoms, which is unsubstituted or substituted with deuterium; or an aryl group having 6 to 30 carbon atoms, which is unsubstituted or substituted with deuterium.

In an exemplary embodiment of the present specification, R1 is hydrogen; deuterium; an alkyl group having 1 to 20 carbon atoms, which is unsubstituted or substituted with deuterium; or an aryl group having 6 to 20 carbon atoms, which is unsubstituted or substituted with deuterium.

In an exemplary embodiment of the present specification, R1 is hydrogen or deuterium.

In an exemplary embodiment of the present specification, m is an integer from 0 to 9.

In an exemplary embodiment of the present specification, m is an integer from 1 to 9.

In an exemplary embodiment of the present specification, m is 0.

In an exemplary embodiment of the present specification, m is 1.

In an exemplary embodiment of the present specification, m is 2.

In an exemplary embodiment of the present specification, m is 3.

In an exemplary embodiment of the present specification, m is 4.

In an exemplary embodiment of the present specification, m is 5.

In an exemplary embodiment of the present specification, m is 6.

In an exemplary embodiment of the present specification, m is 7.

In an exemplary embodiment of the present specification, m is 8.

In an exemplary embodiment of the present specification, m is 9.

In an exemplary embodiment of the present specification, m is 9, and R1 is all deuterium.

In an exemplary embodiment of the present specification, m is 9, and 8 of 9 R1s are deuterium.

In an exemplary embodiment of the present specification, m is 9, and 7 of 9 R1s are deuterium.

In an exemplary embodiment of the present specification, m is 9, and 6 of 9 R1s are deuterium.

In an exemplary embodiment of the present specification, m is 9, and 5 of 9 R1s are deuterium.

In an exemplary embodiment of the present specification, m is 9, and 4 of 9 R1s are deuterium.

In an exemplary embodiment of the present specification, m is 9, and 3 of 9 R1s are deuterium.

In an exemplary embodiment of the present specification, m is 9, and 2 of 9 R1s are deuterium.

In an exemplary embodiment of the present specification, m is 9, and 1 of 9 R1s are deuterium.

In an exemplary embodiment of the present specification, D is deuterium.

In an exemplary embodiment of the present specification, n is an integer from 0 to 8.

In an exemplary embodiment of the present specification, n is an integer from 1 to 8.

In an exemplary embodiment of the present specification, n is 0.

In an exemplary embodiment of the present specification, n is 1.

In an exemplary embodiment of the present specification, n is 2.

In an exemplary embodiment of the present specification, n is 3.

In an exemplary embodiment of the present specification, n is 4.

In an exemplary embodiment of the present specification, n is 5.

In an exemplary embodiment of the present specification, n is 6.

In an exemplary embodiment of the present specification, n is 7.

In an exemplary embodiment of the present specification, n is 8.

In an exemplary embodiment of the present specification, R2 to R6 are the same as or different from each other, and are each independently hydrogen, deuterium, a substituted or unsubstituted alkyl group, or the following Chemical Formula A.

In an exemplary embodiment of the present specification, R2 to R6 are the same as or different from each other, and are each independently hydrogen, deuterium, a substituted or unsubstituted alkyl group having 1 to 60 carbon atoms, or the following Chemical Formula A.

In an exemplary embodiment of the present specification, R2 to R6 are the same as or different from each other, and are each independently hydrogen, deuterium, a substituted or unsubstituted alkyl group having 1 to 30 carbon atoms, or the following Chemical Formula A.

In an exemplary embodiment of the present specification, R2 to R6 are the same as or different from each other, and are each independently hydrogen, deuterium, a substituted or unsubstituted alkyl group having 1 to 20 carbon atoms, or the following Chemical Formula A.

In an exemplary embodiment of the present specification, R2 to R6 are the same as or different from each other, and are each independently hydrogen, deuterium, a substituted or unsubstituted alkyl group having 1 to 10 carbon atoms, or the following Chemical Formula A.

In an exemplary embodiment of the present specification, R2 to R6 are the same as or different from each other, and are each independently hydrogen; deuterium; an alkyl group which is unsubstituted or substituted with deuterium; or the following Chemical Formula A.

In an exemplary embodiment of the present specification, R2 to R6 are the same as or different from each other, and are each independently hydrogen; deuterium; an alkyl group having 1 to 60 carbon atoms, which is unsubstituted or substituted with deuterium; or the following Chemical Formula A.

In an exemplary embodiment of the present specification, R2 to R6 are the same as or different from each other, and are each independently hydrogen; deuterium; an alkyl group having 1 to 30 carbon atoms, which is unsubstituted or substituted with deuterium; or the following Chemical Formula A.

In an exemplary embodiment of the present specification, R2 to R6 are the same as or different from each other, and are each independently hydrogen; deuterium; an alkyl group having 1 to 20 carbon atoms, which is unsubstituted or substituted with deuterium; or the following Chemical Formula A.

In an exemplary embodiment of the present specification, R2 to R6 are the same as or different from each other, and are each independently hydrogen; deuterium; an alkyl group having 1 to 10 carbon atoms, which is unsubstituted or substituted with deuterium; or the following Chemical Formula A.

In an exemplary embodiment of the present specification, R2 to R6 are the same as or different from each other, and are each independently hydrogen, deuterium, or the following Chemical Formula A.

In an exemplary embodiment of the present specification, at least one of R2 and R6 is the following Chemical Formula A.

In an exemplary embodiment of the present specification, one of R2 and R6 is the following Chemical Formula A.

In an exemplary embodiment of the present specification, R2 is the following Chemical Formula A.

In an exemplary embodiment of the present specification, R6 is the following Chemical Formula A.

In an exemplary embodiment of the present specification, R2 is the following Chemical Formula A, and R3 to R6 are the same as or different from each other, and are each independently hydrogen, deuterium, or a substituted or unsubstituted alkyl group.

In an exemplary embodiment of the present specification, R2 is the following Chemical Formula A, and R3 to R6 are the same as or different from each other, and are each independently hydrogen or deuterium.

In an exemplary embodiment of the present specification, R6 is the following Chemical Formula A, and R2 to R5 are the same as or different from each other, and are each independently hydrogen, deuterium, or a substituted or unsubstituted alkyl group.

In an exemplary embodiment of the present specification, R6 is the following Chemical Formula A, and R2 to R5 are the same as or different from each other, and are each independently hydrogen or deuterium.

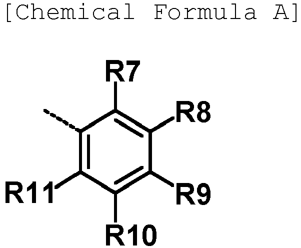

In Chemical Formula A:
R7 to R11 are the same as or different from each other, and are each independently hydrogen, deuterium, a substituted or unsubstituted alkyl group, or a substituted or unsubstituted aryl group, or adjacent substituents are bonded to each other to form a substituted or unsubstituted ring; and
a dotted line (---) is a moiety linked to Chemical Formula 2.

In an exemplary embodiment of the present specification, R7 to R11 are the same as or different from each other, and are each independently hydrogen, deuterium, a substituted or unsubstituted alkyl group, or a substituted or unsubstituted aryl group, or adjacent substituents are bonded to each other to form a substituted or unsubstituted ring.

In an exemplary embodiment of the present specification, R7 to R11 are the same as or different from each other, and are each independently hydrogen, deuterium, a substituted or unsubstituted alkyl group, or a substituted or unsubstituted aryl group, or are bonded to an adjacent group to form a substituted or unsubstituted ring.

In an exemplary embodiment of the present specification, R7 to R11 are the same as or different from each other, and are each independently hydrogen, deuterium, a substituted or unsubstituted alkyl group having 1 to 60 carbon atoms, or a substituted or unsubstituted aryl group having 6 to 60 carbon atoms, or are bonded to an adjacent group to form a substituted or unsubstituted ring.

In an exemplary embodiment of the present specification, R7 to R11 are the same as or different from each other, and are each independently hydrogen, deuterium, a substituted or unsubstituted alkyl group having 1 to 30 carbon atoms, or a substituted or unsubstituted aryl group having 6 to 30 carbon atoms, or are bonded to an adjacent group to form a substituted or unsubstituted ring.

In an exemplary embodiment of the present specification, R7 to R11 are the same as or different from each other, and are each independently hydrogen, deuterium, a substituted or unsubstituted alkyl group having 1 to 20 carbon atoms, or a substituted or unsubstituted aryl group having 6 to 20 carbon atoms, or are bonded to an adjacent group to form a substituted or unsubstituted ring.

In an exemplary embodiment of the present specification, R7 to R11 are the same as or different from each other, and are each independently hydrogen; deuterium; an alkyl group which is unsubstituted or substituted with deuterium; or an aryl group which is unsubstituted or substituted with deuterium, or are bonded to an adjacent group to form a substituted or unsubstituted ring.

In an exemplary embodiment of the present specification, R7 to R11 are the same as or different from each other, and are each independently hydrogen; deuterium; an alkyl group having 1 to 60 carbon atoms, which is unsubstituted or substituted with deuterium; or an aryl group having 6 to 60 carbon atoms, which is unsubstituted or substituted with deuterium, or are bonded to an adjacent group to form a ring which is unsubstituted or substituted with deuterium.

In an exemplary embodiment of the present specification, R7 to R11 are the same as or different from each other, and are each independently hydrogen; deuterium; an alkyl group having 1 to 30 carbon atoms, which is unsubstituted or substituted with deuterium; or an aryl group having 6 to 30 carbon atoms, which is unsubstituted or substituted with deuterium, or are bonded to an adjacent group to form a ring which is unsubstituted or substituted with deuterium.

In an exemplary embodiment of the present specification, R7 to R11 are the same as or different from each other, and are each independently hydrogen; deuterium; an alkyl group having 1 to 20 carbon atoms, which is unsubstituted or substituted with deuterium; or an aryl group having 6 to 20 carbon atoms, which is unsubstituted or substituted with deuterium, or are bonded to an adjacent group to form a ring which is unsubstituted or substituted with deuterium.

In an exemplary embodiment of the present specification, R7 to R11 are the same as or different from each other, and are each independently hydrogen or deuterium.

In an exemplary embodiment of the present specification, the others which are not Chemical Formula A among R1 to R11 are the same as or different from each other, and are each independently hydrogen or deuterium.

In an exemplary embodiment of the present specification, the compound of Chemical Formula 2 includes at least one deuterium.

In an exemplary embodiment of the present specification, Chemical Formula 2 is the following Chemical Formula 2-1.

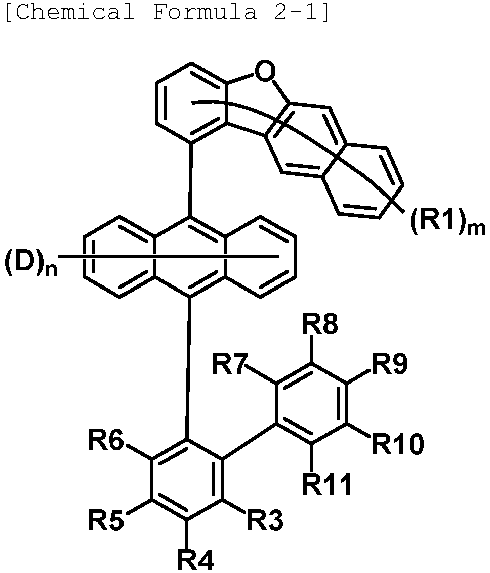

In Chemical Formula 2-1, the definitions of R1, m, D, n and R3 to R11 are the same as the definitions in Chemical Formula 2.

In an exemplary embodiment of the present specification, at least 40% of the compound of Chemical Formula 2 is substituted with deuterium. In another exemplary embodiment, 50% or more of the compound of Chemical Formula 2 is substituted with deuterium. In still another exemplary embodiment, 60% or more of the compound of Chemical Formula 2 is substituted with deuterium. In yet another exemplary embodiment, 70% or more of the compound of Chemical Formula 2 is substituted with deuterium. In still yet another exemplary embodiment, 80% or more of the compound of Chemical Formula 2 is substituted with deuterium. In a further exemplary embodiment, 90% or more of the compound of Chemical Formula 2 is substituted with deuterium. In another further exemplary embodiment, 100% of the compound of Chemical Formula 2 is substituted with deuterium.

In an exemplary embodiment of the present specification, the compound of Chemical Formula 2 includes 40% to 60% of deuterium. In another exemplary embodiment, the compound of Chemical Formula 2 includes 40% to 80% of deuterium. In still another exemplary embodiment, the compound of Chemical Formula 2 includes 60% to 80% of deuterium. In yet another exemplary embodiment, the compound of Chemical Formula 2 includes 80% to 100% of deuterium.

In an exemplary embodiment of the present specification, the compound of Chemical Formula 2 is any one of the following compounds.

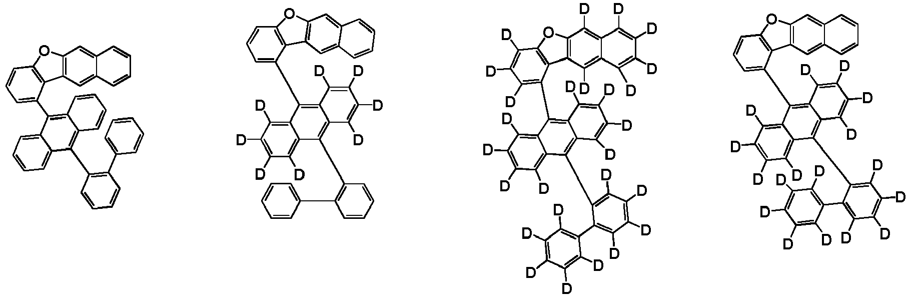

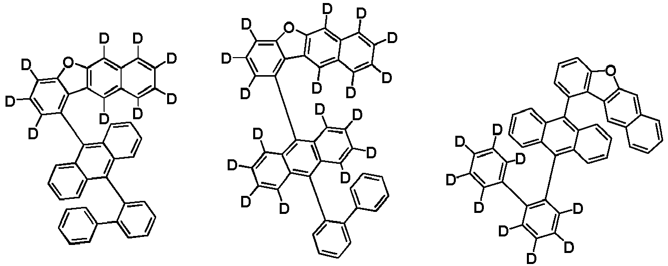

A core structure of the compounds of Chemical Formula 1 and Chemical Formula 2 according to an exemplary embodiment of the present specification may be prepared as in the method of the Preparation Example to be described below The substituent may be bonded by a method known in the art, and the kind and position of the substituent or the number of substituents may be changed according to the technology known in the art.

In the present specification, compounds having various energy band gaps may be synthesized by introducing various substituents into the core structures of the compounds of Chemical Formula 1 and Chemical Formula 2. Further, in the present specification, various substituents may be introduced into the core structures having the structure described above to adjust the HOMO and LUMO energy levels of a compound.

Hereinafter, an organic light emitting device will be described.

When one member is disposed "on" another member in the present specification, this includes not only a case where the one member is brought into contact with another member, but also a case where still another member is present between the two members.

When one part "includes" one constituent element in the present specification, unless otherwise specifically described, this does not mean that another constituent element is excluded, but means that another constituent element may be further included.

The organic light emitting device according to the present specification includes: an anode; a cathode; and a first organic material layer and a second organic material layer provided between the anode and the cathode, in which the first organic material layer includes a compound of the following Chemical Formula 1 and the second organic material layer includes a compound of the following Chemical Formula 2.

The organic light emitting device of the present invention may be manufactured by typical methods and materials for manufacturing an organic light emitting device, except that an organic material layer is formed using the above-described compound of Chemical Formula 1 and the above-described compound of Chemical Formula 2.

The compound may be formed as an organic material layer by not only a vacuum deposition method, but also a solution application method when an organic light emitting device is manufactured. Here, the solution application method means spin coating, dip coating, inkjet printing, screen printing, a spray method, roll coating, and the like, but is not limited thereto.

The organic material layer of the organic light emitting device of the present specification may also have a single-layered structure, but may have a multi-layered structure in which two or more organic material layers are stacked. For example, the organic light emitting device of the present invention may have a structure including one or more layers of a hole injection layer, a hole transport layer, an electron blocking layer, a light emitting layer, a hole injection and transport layer, an electron transport layer, an electron injection layer, a hole blocking layer, and an electron transport and injection layer as organic material layers. However, the structure of the organic light emitting device of the present specification is not limited thereto, and may include a fewer or greater number of organic material layers.

In an exemplary embodiment of the present specification, the first organic material layer may be disposed between the second organic material layer and the cathode.

In an exemplary embodiment of the present specification, the first organic material layer may be an electron transport layer, an electron injection layer, or an electron transport and injection layer, and the electron transport layer, the electron injection layer, or the electron transport and injection layer may include the compound of Chemical Formula 1.

In an exemplary embodiment of the present specification, the second organic material layer may be a light emitting layer, and the light emitting layer may include the compound of Chemical Formula 2.

In an exemplary embodiment of the present specification, the light emitting layer includes the compound of Chemical Formula 2 as a host, and may further include a dopant.

In the organic light emitting device according to an exemplary embodiment of the present specification, the organic material layer may include a hole injection layer, hole transport layer, or electron blocking layer having two or more layers.

In the organic light emitting device according to an exemplary embodiment of the present specification, the organic material layer may include an electron injection layer, electron transport layer, or hole blocking layer having two or more layers.

In an exemplary embodiment of the present specification, the first organic material layer including the compound of Chemical Formula 1 and the second organic material layer including the compound of Chemical Formula 2 have a thickness of 10 Å to 600 Å, preferably 50 Å to 500 Å, and more preferably 200 Å to 400 Å.

In another exemplary embodiment, the first organic material layer and the second organic material layer may further include another organic compound, metal, or metal compound in addition to the above-described compound of Chemical Formula 1 and the above-described compound of Chemical Formula 2.

In still another exemplary embodiment, the first organic material layer and the second organic material layer do not include another organic compound, metal, or metal compound in addition to the above-described compound of Chemical Formula 1 and the above-described compound of Chemical Formula 2.

In an exemplary embodiment of the present specification, the first organic material layer and the second organic material layer may be in contact with each other.

In an exemplary embodiment of the present specification, the first organic material layer and the second organic material layer may not be in contact with each other.

In an exemplary embodiment of the present specification, an organic material layer having one or more layers is included between the first organic material layer and the second organic material layer.

In an exemplary embodiment of the present specification, a hole blocking layer is included between the first organic material layer and the second organic material layer.

In the organic light emitting device according to an exemplary embodiment of the present specification, the light emitting layer further includes a fluorescent dopant or a phosphorescent dopant. In this case, the dopant in the light emitting layer is included in an amount of 1 part by weight to 50 parts by weight with respect to 100 parts by weight of a host.

In this case, it is possible to use a phosphorescent material such as (4,6-F2ppy)2Irpic, or a fluorescent material such as spiro-DPVBi, spiro-6P, distyryl benzene (DSB), distyryl arylene (DSA), a PFO-based polymer, a PPV-based polymer, an anthracene-based compound, a pyrene-based compound, and a boron-based compound as the dopant, but the dopant is not limited thereto.

In an exemplary embodiment of the present specification, the organic light emitting device includes: an anode; a cathode; and an organic material layer having two or more layers provided between the anode and the cathode, and at least one of the organic material layers having two or more layers includes the compound of Chemical Formula 1 and the compound of Chemical Formula 2.

In an exemplary embodiment of the present specification, as the organic material layer having two or more layers, two or more may be selected from the group consisting of a light emitting layer, a hole transport layer, a hole injection layer, a hole transport and injection layer, and an electron blocking layer.

In an exemplary embodiment of the present specification, as the organic material layer having two or more layers, two or more may be selected from the group consisting of a light emitting layer, an electron transport layer, an electron injection layer, an electron transport and injection layer, an electron adjusting layer, and a hole blocking layer.

In an exemplary embodiment of the present specification, the organic material layer includes an electron transport layer having two or more layers, and at least one of the electron transport layers having two or more layers includes the compound of Chemical Formula 1 and the compound of Chemical Formula 2. Specifically, in an exemplary embodiment of the present specification, the compound of Chemical Formula 1 and the compound of Chemical Formula 2 may also be included in one layer of the electron transport layer having two or more layers, and may be included in each of the electron transport layer having two or more layers.

Further, in an exemplary embodiment of the present specification, when the compounds are included in each of the electron transport layer having two or more layers, the other materials except for the compound of Chemical Formula 1 and the compound of Chemical Formula 2 may be the same as or different from each other.

When an organic material layer including the compound of Chemical Formula 1 or the compound of Chemical Formula 2 is an electron transport layer, an electron injection layer, or an electron transport and injection layer, the electron transport layer, the electron injection layer, or the electron transport and injection layer may further include an n-type dopant. As the n-type dopant, those known in the art may be used, and for example, a metal or a metal complex may be used. For example, the electron transport layer including the compound of Chemical Formula 1 and the compound of Chemical Formula 2 may further include lithium quinolate (LiQ). According to an example, the total of the compound of Chemical Formula 1 and the compound of Chemical Formula 2 and the n-type dopant may be included at a weight ratio of 2:8 to 8:2, for example, 4:6 to 6:4.

According to an example, the total of the compound of Chemical Formula 1 and the compound of Chemical Formula 2 and the n-type dopant may be included at a weight ratio of 1:1.

The organic light emitting device according to an exemplary embodiment of the present specification further includes an organic material layer having one or more layers between the anode and the cathode, and the organic material layer may further include one or more layers of a hole transport layer, a hole injection layer, a hole transport and injection layer, an electron blocking layer, a light emitting layer, an electron transport layer, an electron injection layer, an electron transport and injection layer, and a hole blocking layer.

The organic light emitting device according to an exemplary embodiment of the present specification may further include a light emitting layer having one or more layers.

The organic light emitting device according to an exemplary embodiment of the present specification further includes one or more light emitting layers in addition to the above light emitting layer, and each light emitting layer may include the above-described host compound.

The organic light emitting device according to an exemplary embodiment of the present specification further includes one or more light emitting layers in addition to the above light emitting layer, and each light emitting layer further includes a fluorescent dopant or a phosphorescent dopant. In this case, the dopant in the light emitting layer is included in an amount of 1 part by weight to 50 parts by weight with respect to 100 parts by weight of a host.

The organic light emitting device according to an exemplary embodiment of the present specification may include a light emitting layer having two or more layers.

The organic light emitting device according to an exemplary embodiment of the present specification includes a light emitting layer having two or more layers, at least one light emitting layer includes a fluorescent dopant, and at least one different light emitting layer includes a phosphorescent dopant.

The organic light emitting device according to an exemplary embodiment of the present specification may include a light emitting layer having three or more layers.

In the organic light emitting device according to an exemplary embodiment of the present specification, the light emitting layer has a maximum light emission peak of 400 nm to 500 nm.

The organic light emitting device according to an exemplary embodiment of the present specification includes a light emitting layer having two or more layers, and the light emitting layer having two or more layers has a maximum light emission peak of each 400 nm to 500 nm.

The organic light emitting device according to an exemplary embodiment of the present specification further includes a light emitting layer having one or more layers, and each light emitting layer exhibits each different wavelength band.

The organic light emitting device according to an exemplary embodiment of the present specification includes a light emitting layer having three or more layers, a light emitting layer having one layer (Light emitting layer 1) has a maximum light emission peak of 400 nm to 500 nm, the maximum light emission peak of a light emitting layer having another layer (Light emitting layer 2) may exhibit a maximum light emission peak of 510 nm to 580 nm, or 610 nm to 680 nm, and the maximum light emission peak of a light emitting layer having still another layer (Light emitting layer 3) may exhibit a maximum light emission peak of 400 nm to 500 nm.

In addition, according to an exemplary embodiment of the present application, the light emitting layer having two or more layers may be positioned vertically or horizontally between the anode and the cathode.

According to an exemplary embodiment of the present application, the light emitting layer having three or more layers is positioned vertically from the anode to the cathode. In this case, the emitting layer having three or more layers may be all a blue fluorescent emitting layer.

When the organic light emitting device according to an exemplary embodiment of the present specification includes a plurality of light emitting layers, an organic material layer having one or more layers is further provided between the plurality of light emitting layers, and the organic material layer may further include one or more layers of a hole transport layer, a hole injection layer, a hole transport and injection layer, an electron blocking layer, a charge generation layer, a light emitting layer, an electron transport layer, an electron injection layer, an electron transport and injection layer, and a hole blocking layer.

In an exemplary embodiment of the present specification, the organic light emitting device may be a normal type organic light emitting device in which an anode, an organic material layer having one or more layers, and a cathode are sequentially stacked on a substrate.

In an exemplary embodiment of the present specification, the organic light emitting device may be an inverted type organic light emitting device in which a cathode, an organic material layer having one or more layers, and an anode are sequentially stacked on a substrate.

The organic light emitting device may have, for example, the stacking structure described below, but the stacking structure is not limited thereto.
(1) Anode/Hole transport layer/Light emitting layer/Cathode
(2) Anode/Hole injection layer/Hole transport layer/Light emitting layer/Cathode
(3) Anode/Hole injection layer/Hole buffer layer/Hole transport layer/Light emitting layer/Cathode
(4) Anode/Hole transport layer/Light emitting layer/Electron transport layer/Cathode
(5) Anode/Hole transport layer/Light emitting layer/Electron transport layer/Electron injection layer/Cathode
(6) Anode/Hole injection layer/Hole transport layer/Light emitting layer/Electron transport layer/Cathode
(7) Anode/Hole injection layer/Hole transport layer/Light emitting layer/Electron transport layer/Electron injection layer/Cathode
(8) Anode/Hole injection layer/Hole buffer layer/Hole transport layer/Light emitting layer/Electron transport layer/Cathode
(9) Anode/Hole injection layer/Hole buffer layer/Hole transport layer/Light emitting layer/Electron transport layer/Electron injection layer/Cathode
(10) Anode/Hole transport layer/Electron blocking layer/Light emitting layer/Electron transport layer/Cathode
(11) Anode/Hole transport layer/Electron blocking layer/Light emitting layer/Electron transport layer/Electron injection layer/Cathode
(12) Anode/Hole injection layer/Hole transport layer/Electron blocking layer/Light emitting layer/Electron transport layer/Cathode
(13) Anode/Hole injection layer/Hole transport layer/Electron blocking layer/Light emitting layer/Electron transport layer/Electron injection layer/Cathode
(14) Anode/Hole transport layer/Light emitting layer/Hole blocking layer/Electron transport layer/Cathode
(15) Anode/Hole transport layer/Light emitting layer/Hole blocking layer/Electron transport layer/Electron injection layer/Cathode
(16) Anode/Hole injection layer/Hole transport layer/Light emitting layer/Hole blocking layer/Electron transport layer/Cathode
(17) Anode/Hole injection layer/Hole transport layer/Light emitting layer/Hole blocking layer/Electron transport layer/Electron injection layer/Cathode
(18) Anode/Hole injection layer/First hole transport layer/Second hole transport layer/Light emitting layer/Electron transport and injection layer/Cathode

The structure of the organic light emitting device of the present specification may have structures as illustrated in FIGS. 1 to 3, but is not limited thereto.

FIG. 1 illustrates a structure of an organic light emitting device in which a substrate 1, an anode 2, a second organic material layer 22, a first organic material layer 21, and a cathode 10 are sequentially stacked. In the structure as described above, the compound of Chemical Formula 1 may be included in the first organic material layer 21, and the compound of Chemical Formula 2 may be included in the second organic material layer 22.

FIG. 2 exemplifies a structure of an organic light emitting device in which a substrate 1, an anode 2, a hole injection layer 3, a hole transport layer 4, an electron blocking layer 5, a light emitting layer 6, a hole blocking layer 7, an electron transport layer 8, an electron injection layer 9, and a cathode 10 are sequentially stacked. In the structure as described above, the compound of Chemical Formula 1 may be included in the electron transport layer 8 or the electron injection layer 9, and the compound of Chemical Formula 2 may be included in the light emitting layer 6.

FIG. 3 illustrates a structure of an organic light emitting device in which a substrate 1, an anode 2, a hole injection layer 3, a hole transport layer 4, an electron blocking layer 5, a light emitting layer 6, a hole blocking layer 7, an electron injection and transport layer 11, and a cathode 10 are sequentially stacked. In the structure as described above, the compound of Chemical Formula 1 may be included in the electron injection and transport layer 11, and the compound of Chemical Formula 2 may be included in the light emitting layer 6.

According to an exemplary embodiment of the present specification, the organic light emitting device may have a tandem structure in which two or more independent devices are connected in series. In an exemplary embodiment, the tandem structure may be in the form of each organic light emitting device joined by a charge generating layer. Since a device having a tandem structure can be driven with a current lower than that of a unit device based on the same brightness, there is an advantage in that the service life characteristic of the device is significantly improved.

In an exemplary embodiment of the present specification, the electron transport and injection layer and the light emitting layer may be provided adjacent to each other. For example, the electron transport and injection layer and the light emitting layer may be provided to be brought into physical contact with each other.

In an exemplary embodiment of the present specification, the electron transport layer and the light emitting layer may be provided adjacent to each other. For example, the electron transport layer and the light emitting layer may be provided to be brought into physical contact with each other.

In an exemplary embodiment of the present specification, the hole blocking layer and the light emitting layer may be provided adjacent to each other. For example, the hole blocking layer and the light emitting layer may be provided to be brought into physical contact with each other.

The organic light emitting device of the present specification may be manufactured by the materials and methods known in the art, except that one or more layers of the organic material layer include the compound, that is, the compound of Chemical Formula 1 and the compound of Chemical Formula 2.

When the organic light emitting device includes a plurality of organic material layers, the organic material layers may be formed with materials the same as or different from each other.

For example, the organic light emitting device according to the present specification may be manufactured by depositing a metal or a metal oxide having conductivity, or an alloy thereof on a substrate to form an anode, forming an organic material layer including a hole injection layer, a hole transport layer, a light emitting layer, an electron blocking layer, an electron transport layer, and an electron injection layer thereon, and then depositing a material, which may be used as a cathode, thereon, by using a physical vapor deposition (PVD) method such as sputtering or e-beam evaporation. In addition to the method described above, an organic light emitting device may be made by sequentially depositing a cathode material, an organic material layer, and an anode material on a substrate.

The organic material layer may further include one or more layers of a hole transport layer, a hole injection layer, an electron blocking layer, an electron transport and injection layer, an electron transport layer, an electron injection layer, a hole blocking layer, and a hole transport and injection layer.

The organic material layer may have a multi-layered structure including a hole injection layer, a hole transport layer, an electron blocking layer, a light emitting layer, a hole blocking layer, an electron transport layer, an electron injection layer, or an electron transport and injection layer, and the like, but is not limited thereto, and may also have a single-layered structure. Further, the organic material layer may be manufactured to include a fewer number of layers by a method such as a solvent process, for example, spin coating, dip coating, doctor blading, screen printing, inkjet printing, or a thermal transfer method instead of a deposition method, using various polymer materials.

The anode is an electrode which injects holes, and as an anode material, materials having a high work function are usually preferred so as to facilitate the injection of holes into an organic material layer. Specific examples of the anode material which may be used in the present invention include: a metal, such as vanadium, chromium, copper, zinc, and gold, or an alloy thereof; a metal oxide, such as zinc oxide, indium oxide, indium tin oxide (ITO), and indium zinc oxide (IZO); a combination of a metal and an oxide, such as ZnO : Al or SnO₂ : Sb; a conductive polymer, such as poly(3-methylthiophene), poly[3,4-(ethylene-1,2-dioxy)thiophene] (PEDOT), polypyrrole, and polyaniline; and the like, but are not limited thereto.

The cathode is an electrode which injects electrons, and as a cathode material, materials having a low work function are usually preferred so as to facilitate the injection of electrons into an organic material layer. Specific examples of the cathode material include: a metal such as magnesium, calcium, sodium, potassium, titanium, indium, yttrium, lithium, gadolinium, aluminum, silver, tin, and lead, or an alloy thereof; a multi-layer structured material, such as LiF/Al or LiO₂/Al; and the like, but are not limited thereto.

The hole injection layer is a layer which serves to facilitate the injection of holes from an anode to a light emitting layer, and a hole injection material is preferably a material which may proficiently accept holes from an anode at a low voltage, and the highest occupied molecular orbital (HOMO) of the hole injection material is preferably a value between the work function of the anode material and the HOMO of the neighboring organic material layer. Specific examples of the hole injection material include the above-described compounds or metal porphyrin, oligothiophene, arylamine-based organic materials, hexanitrile hexaazatriphenylene-based organic materials, quinacridone-based organic materials, perylene-based organic materials, anthraquinone, polyaniline-based and polythiophene-based conductive polymers, and the like, but are not limited thereto.

The hole injection layer may have a thickness of 1 Å to 150 Å. When the hole injection layer has a thickness of 1 Å or more, there is an advantage in that it is possible to prevent hole injection characteristics from deteriorating, and when the hole injection layer has a thickness of 150 Å or less, there is an advantage in that it is possible to prevent the driving voltage from being increased in order to improve the movement of holes due to the too thick hole injection layer.

In an exemplary embodiment of the present specification, the hole injection material may include an arylamine compound including a carbazole group and a tetrafluorobenzonitrile compound. According to an example, the amine compound is Het101-L101-N(Ar101) (Ar102), where Het101 is a substituted or unsubstituted carbazole group, L101 is a direct bond or a substituted or unsubstituted arylene group, and Ar101 and Ar102 are the same as or different from each other, and may be each independently a substituted or unsubstituted aryl group. The amine compound and the tetrafluorobenzonitrile compound may be included at an appropriate weight ratio, and according to an example, the amine compound and the tetrafluorobenzonitrile compound may be included at a weight ratio of 99.9:0.1 to 90:10.

The hole transport layer may serve to facilitate the transport of holes. A hole transport material is suitably a material having high hole mobility which may accept holes from an anode or a hole injection layer and transfer the holes to a light emitting layer. Specific examples thereof include the above-described compounds or arylamine-based organic materials, conductive polymers, block copolymers having conjugated parts and non-conjugated parts together, and the like, but are not limited thereto.

In an exemplary embodiment of the present specification, it is possible to include an arylamine-based compound including a carbazole group as the hole transport material.

A hole buffer layer may be additionally provided between a hole injection layer and a hole transport layer, and may include the above-described compounds or hole injection or transport materials known in the art.

An electron blocking layer may be provided between a hole transport layer and a light emitting layer. For the electron blocking layer, the above-described compounds or the materials known in the art may be used, and specifically, in an exemplary embodiment of the present specification, an arylamine-based compound including a phenanthrenyl group may be included as the electron blocking material, but the electron blocking material is not limited thereto.

The light emitting layer may emit red, green, or blue light, and may be composed of a phosphorescent material or a fluorescent material. The light emitting material is a material which may receive holes and electrons from a hole transport layer and an electron transport layer, respectively, and combine the holes and the electrons to emit light in a visible ray region, and is preferably a material having high quantum efficiency for fluorescence or phosphorescence. Specific examples thereof include: 8-hydroxy-quinoline aluminum complexes (Alq₃); carbazole-based compounds; dimerized styryl compounds; BAlq; 10-hydroxybenzoquinoline-metal compounds; benzoxazole-based, benzthiazole-based and benzimidazole-based compounds; poly(p-phenylenevinylene) (PPV)-based polymers; spiro compounds; polyfluorene, lubrene, and the like, but are not limited thereto.

Examples of the host material for the light emitting layer include fused aromatic ring derivatives, or hetero ring-containing compounds, and the like. Specifically, examples of the fused aromatic ring derivative include anthracene derivatives, pyrene derivatives, naphthalene derivatives, pentacene derivatives, phenanthrene compounds, fluoranthene compounds, and the like, and examples of the hetero ring-containing compound include carbazole derivatives, dibenzofuran derivatives, ladder-type furan compounds, pyrimidine derivatives, and the like, but the examples thereof are not limited thereto.

When the light emitting layer emits red light, it is possible to use a phosphorescent material such as bis(1-phenylisoquinoline)acetylacetonate iridium (PIQIr(acac)), bis(1-phenylquinoline)acetylacetonate iridium (PQIr(acac)), tris(1-phenylquinoline)iridium (PQIr), or octaethylporphyrin platinum (PtOEP), or a fluorescent material such as tris(8-hydroxyquinolino)aluminum (Alq₃) as a light emitting dopant, but the light emitting dopant is not limited thereto. When the light emitting layer emits green light, it is possible to use a phosphorescent material such as fac tris(2-phenylpyridine)iridium (Ir(ppy)₃), or a fluorescent material such as tris(8-hydroxyquinolino)aluminum (Alq₃), an anthracene-based compound, a pyrene-based compound, and a boron-based compound as a light emitting dopant, but the light emitting dopant is not limited thereto. When the light emitting layer emits blue light, it is possible to use a phosphorescent material such as (4,6-F₂ppy)₂Irpic, or a fluorescent material such as spiro-DPVBi, spiro-6P, distyryl benzene (DSB), distyryl arylene (DSA), a PFO-based polymer, a PPV-based polymer, an anthracene-based compound, a pyrene-based compound, and a boron-based compound as a light emitting dopant, but the light emitting dopant is not limited thereto.

In an exemplary embodiment of the present specification, a compound according to Chemical Formula 2 of the present application, an anthracene-based compound, a boron-based compound, or the like may be used as the light emitting layer material.

A hole blocking layer may be provided between the electron transport layer and the light emitting layer, and the hole blocking layer is a layer which blocks holes from reaching a cathode, and may be generally formed under the same conditions as those of the hole injection layer. Specific examples thereof may include oxadiazole derivatives or triazole derivatives, triazine derivatives, phenanthroline derivatives, BCP, aluminum complexes and the like, but are not limited thereto.

In an exemplary embodiment of the present specification, a compound of the following Chemical Formula HB may be included as the hole blocking material.

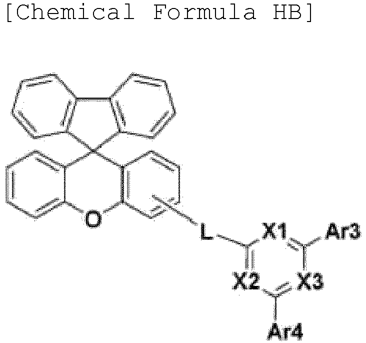

In Chemical Formula HB:
L is a direct bond, a substituted or unsubstituted arylene group, a substituted or unsubstituted alkylene group, a substituted or unsubstituted divalent alkoxy group, a substituted or unsubstituted divalent alkenyl group, or a substituted or unsubstituted heteroarylene group;
X1 is N or CR11, X2 is N or CR12, and X3 is N or CR13;
at least one of X1 to X3 is N;
R11 to R13 are the same as or different from each other, and are each independently hydrogen, deuterium, a cyano group, a nitro group, a hydroxyl group, a carbonyl group, an ester group, an imide group, an amide group, a substituted or unsubstituted alkyl group, a substituted or unsubstituted cycloalkyl group, a substituted or unsubstituted alkoxy group, a substituted or unsubstituted aryloxy group, a substituted or unsubstituted alkylthioxy group, a substituted or unsubstituted arylthioxy group, a substituted or unsubstituted alkylsulfoxy group, a substituted or unsubstituted arylsulfoxy group, a substituted or unsubstituted alkenyl group, a substituted or unsubstituted silyl group, a substituted or unsubstituted boron group, a substituted or unsubstituted amine group, a substituted or unsubstituted arylphosphine group, a substituted or unsubstituted phosphine oxide group, a substituted or unsubstituted aryl group, or a substituted or unsubstituted heteroaryl group; and
Ar3 and Ar4 are the same as or different from each other, and are each independently hydrogen, deuterium, a substituted or unsubstituted arylalkyl group, a substituted or unsubstituted arylalkenyl group, a substituted or unsubstituted aryl group, or a substituted or unsubstituted heteroaryl group.

According to an exemplary embodiment of the present specification, L is a direct bond, a substituted or unsubstituted arylene group, a substituted or unsubstituted alkylene group, a substituted or unsubstituted divalent alkoxy group, a substituted or unsubstituted divalent alkenyl group, or a substituted or unsubstituted heteroarylene group.

According to an exemplary embodiment of the present specification, L is a direct bond, a substituted or unsubstituted arylene group, or a substituted or unsubstituted heteroarylene group.

According to an exemplary embodiment of the present specification, L is a direct bond or a substituted or unsubstituted arylene group.

According to an exemplary embodiment of the present specification, L is a direct bond or a substituted or unsubstituted arylene group having 6 to 30 carbon atoms.

According to an exemplary embodiment of the present specification, L is a direct bond or a substituted or unsubstituted arylene group having 6 to 20 carbon atoms.

According to an exemplary embodiment of the present specification, L is a direct bond or a substituted or unsubstituted arylene group having 6 to 12 carbon atoms.

According to an exemplary embodiment of the present specification, L is a direct bond or a substituted or unsubstituted arylene group having 6 to 10 carbon atoms.

According to an exemplary embodiment of the present specification, L is a direct bond, a substituted or unsubstituted phenylene group, or a substituted or unsubstituted biphenylene group.

According to an exemplary embodiment of the present specification, L is a direct bond, a phenylene group, or a biphenylene group.

According to an exemplary embodiment of the present specification, L is a direct bond or a phenylene group.

According to an exemplary embodiment of the present specification, L is a direct bond.

According to an exemplary embodiment of the present specification, R11 to R13 are the same as or different from each other, and are each independently hydrogen, deuterium, a substituted or unsubstituted aryl group having 6 to 30 carbon atoms, or a substituted or unsubstituted heteroaryl group having 2 to 30 carbon atoms.

According to an exemplary embodiment of the present specification, R11 to R13 are the same as or different from each other, and are each independently hydrogen, deuterium, a substituted or unsubstituted aryl group having 6 to 20 carbon atoms, or a substituted or unsubstituted heteroaryl group having 2 to 20 carbon atoms.

According to an exemplary embodiment of the present specification, R11 to R13 are hydrogen or deuterium.

According to an exemplary embodiment of the present specification, R11 to R13 are hydrogen.

According to an exemplary embodiment of the present specification, Ar3 and Ar4 are the same as or different from each other, and are each independently hydrogen, deuterium, a substituted or unsubstituted aryl group, or a substituted or unsubstituted heteroaryl group.

According to an exemplary embodiment of the present specification, Ar3 and Ar4 are the same as or different from each other, and are each independently hydrogen, deuterium, a substituted or unsubstituted aryl group having 6 to 60 carbon atoms, or a substituted or unsubstituted heteroaryl group having 2 to 60 carbon atoms.

According to an exemplary embodiment of the present specification, Ar3 and Ar4 are the same as or different from each other, and are each independently hydrogen, deuterium, a substituted or unsubstituted aryl group having 6 to 30 carbon atoms, or a substituted or unsubstituted heteroaryl group having 2 to 30 carbon atoms.

According to an exemplary embodiment of the present specification, Ar3 and Ar4 are the same as or different from each other, and are each independently hydrogen, deuterium, a substituted or unsubstituted aryl group having 6 to 20 carbon atoms, or a substituted or unsubstituted heteroaryl group having 2 to 20 carbon atoms.

According to an exemplary embodiment of the present specification, Ar3 and Ar4 are the same as or different from each other, and are each independently hydrogen, deuterium, a substituted or unsubstituted phenyl group, or a substituted or unsubstituted biphenyl group.

According to an exemplary embodiment of the present specification, Ar3 and Ar4 are the same as or different from each other, and are each independently a phenyl group or a biphenyl group.

In an exemplary embodiment of the present specification, Chemical Formula HB is any one of the following Chemical Formulae HB-A to HB-D.

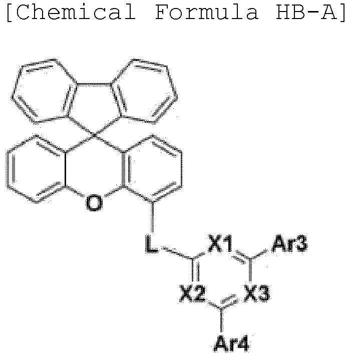

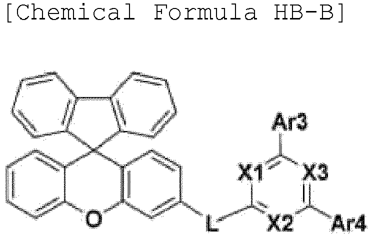

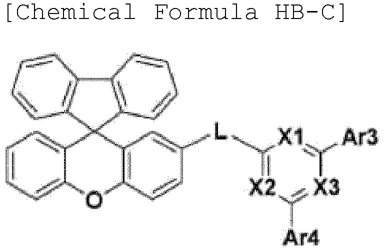

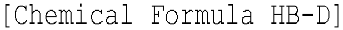

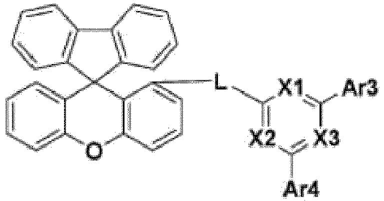

In Chemical Formulae HB-A to HB-D, the definitions of L, Ar3, Ar4 and X1 to X3 are the same as the definitions in Chemical Formula HB.

The electron transport layer may serve to facilitate the transport of electrons. An electron transport material is suitably a material having high electron mobility which may proficiently accept electrons from a cathode and transfer the electrons to a light emitting layer. Specific examples thereof include: the Al complexes of 8-hydroxyquinoline; complexes including Alq3; organic radical compounds; hydroxyflavone-metal complexes; and the like, but are not limited thereto. The electron transport layer may have a thickness of 1 to 500 Å. When the electron transport layer has a thickness of 1 Å or more, there is an advantage in that it is possible to prevent electron transport characteristics from deteriorating, and when the electron transport layer has a thickness of 500 Å or less, there is an advantage in that it is possible to prevent the driving voltage from being increased in order to improve the movement of electrons due to the too thick electron transport layer.

The electron injection layer may serve to facilitate the injection of electrons. An electron injection material is preferably a compound which has a capability of transporting electrons, an effect of injecting electrons from a cathode, and an excellent effect of injecting electrons into a light emitting layer or a light emitting material, prevents excitons produced from a light emitting layer from moving to a hole injection layer, and is also excellent in the ability to form a thin film. Specific examples thereof include fluorenone, anthraquinodimethane, diphenoquinone, thiopyran dioxide, oxazole, oxadiazole, triazole, imidazole, perylenetetracarboxylic acid, fluorenylidene methane, anthrone, and the like, and derivatives thereof, metal complex compounds, nitrogen-containing 5-membered ring derivatives, and the like, but are not limited thereto.

Examples of the metal complex compounds include 8-hydroxyquinolinato lithium, bis(8-hydroxyquinolinato) zinc, bis(8-hydroxyquinolinato) copper, bis(8-hydroxyquinolinato) manganese, tris(8-hydroxyquinolinato) aluminum, tris(2-methyl-8-hydroxyquinolinato) aluminum, tris(8-hydroxyquinolinato) gallium, bis(10-hydroxybenzo[h]quinolinato) beryllium, bis(10-hydroxybenzo[h]quinolinato) zinc, bis(2-methyl-8-quinolinato) chlorogallium, bis(2-methyl-8-quinolinato) (o-cresolato) gallium, bis(2-methyl-8-quinolinato)(1-naphtholato) aluminum, bis(2-methyl-8-quinolinato)(2-naphtholato) gallium, and the like, but are not limited thereto.

In an exemplary embodiment of the present specification, the electron injection and transport material may include the compound according to Chemical Formula 1 of the present application or a triazine compound, and may further include an n-type dopant or organic metal compound. According to an example, the n-type dopant or organic metal compound may be LiQ, and the triazole compound and the n-type dopant (or organic metal compound) may be included at a weight ratio of 2:8 to 8:2, for example, 4:6 to 6:4. The organic light emitting device according to the present invention may be a top emission type, a bottom emission type, or a dual emission type according to the material to be used.

### [Mode for Invention]

Hereinafter, the present specification will be described in detail with reference to Examples for specifically describing the present specification. However, the Examples according to the present specification may be modified in various forms, and it is not interpreted that the scope of the present application is limited to the Examples described in detail below. The Examples of the present application are provided to explain the present specification more completely to a person with ordinary skill in the art.

### <Preparation Example 1>

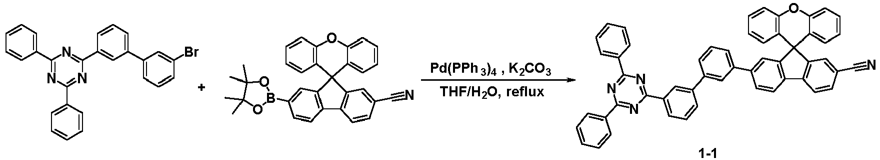

After compounds 2-(3'-bromo-[1,1'-biphenyl]-3-yl)-4,6-diphenyl-1,3,5-triazine (5.50 g, 11.84 mmol) and 7-(4,4,5,5-tetramethyl-1,3,2-dioxaborolan-2-yl)spiro[fluorene-9,9'-xanthene]-2-carbonitrile (6.30 g, 13.03 mmol) were completely dissolved in 240 ml of tetrahydrofuran in a 500-ml round bottom flask under a nitrogen atmosphere, an aqueous 2 M potassium carbonate solution (120 ml) was added thereto, tetrakis-(triphenylphosphine)palladium (0.41 g, 0.36 mmol) was added thereto, and then the resulting mixture was heated and stirred for 8 hours. The temperature was lowered to room temperature, the aqueous layer was removed, and the residue was dried over anhydrous magnesium sulfate, and then concentrated under reduced pressure, and recrystallized with 320 ml of toluene to prepare Compound 1-1 (5.88 g, 73%) .
MS[M+H]⁺= 741

### <Preparation Example 2>

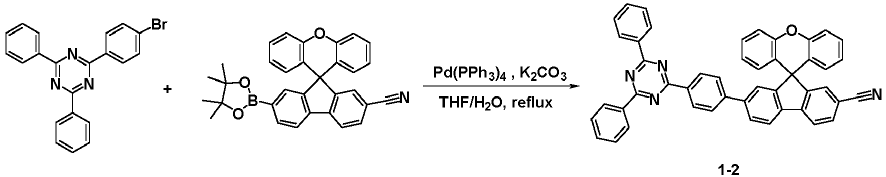

After compounds 2-(4-bromophenyl)-4,6-diphenyl-1,3,5-triazine (5.50 g, 14.18 mmol) and 7-(4,4,5,5-tetramethyl-1,3,2-dioxaborolan-2-yl)spiro[fluorene-9,9'-xanthene]-2-carbonitrile (7.54 g, 15.59 mmol) were completely dissolved in 240 ml of tetrahydrofuran in a 500-ml round bottom flask under a nitrogen atmosphere, an aqueous 2 M potassium carbonate solution (120 ml) was added thereto, tetrakis-(triphenylphosphine)palladium (0.49 g, 0.43 mmol) was added thereto, and then the resulting mixture was heated and stirred for 5 hours. The temperature was lowered to room temperature, the aqueous layer was removed, and the residue was dried over anhydrous magnesium sulfate, and then concentrated under reduced pressure, and recrystallized with 310 ml of toluene to prepare Compound 1-2 (6.21g, 66%).
MS[M+H]⁺= 665

### <Preparation Example 3>

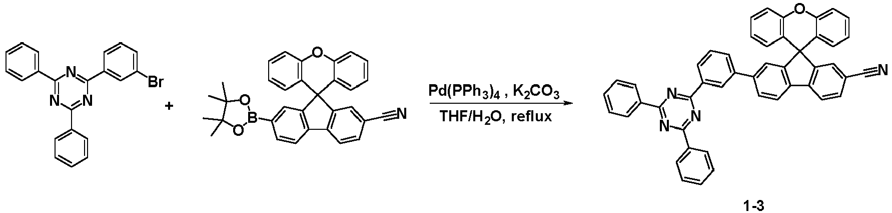

After compounds 2-(3-bromophenyl)-4,6-diphenyl-1,3,5-triazine (5.50 g, 14.18 mmol) and 7-(4,4,5,5-tetramethyl-1,3,2-dioxaborolan-2-yl)spiro[fluorene-9,9'-xanthene]-2-carbonitrile (7.54 g, 15.59 mmol) were completely dissolved in 260 ml of tetrahydrofuran in a 500-ml round bottom flask under a nitrogen atmosphere, an aqueous 2 M potassium carbonate solution (130ml) was added thereto, tetrakis-(triphenylphosphine)palladium (0.49g, 0.43 mmol) was added thereto, and then the resulting mixture was heated and stirred for 3 hours. The temperature was lowered to room temperature, the aqueous layer was removed, and the residue was dried over anhydrous magnesium sulfate, and then concentrated under reduced pressure, and recrystallized with 280 ml of ethyl acetate to prepare Compound 1-3 (6.41 g, 68%).
MS[M+H]⁺= 665

### <Preparation Example 4>

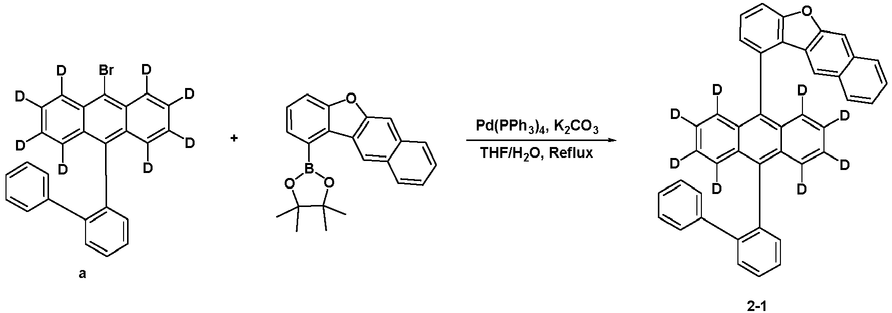

Compound a (6.50 g, 15.57 mmol) and 4,4,5,5-tetramethyl-2-(naphtho[2,3-b]benzofuran-1-yl)-1,3,2-dioxaborolane (5.90 g, 17.13 mmol) were completely dissolved in 240 ml of tetrahydrofuran in a 500-ml round bottom flask under a nitrogen atmosphere, and then an aqueous 2 M potassium carbonate solution (120 ml) was added thereto, tetrakis-(triphenylphosphine)palladium (0.54 g, 0.47 mmol) was added thereto, and then the resulting mixture was heated and stirred for 4 hours. The temperature was lowered to room temperature, the aqueous layer was removed, and the residue was dried over anhydrous magnesium sulfate, and then concentrated under reduced pressure, and recrystallized with 320 ml of ethyl acetate to prepare Compound 2-1 (5.91 g, 68%).
MS[M+H]⁺= 555

### <Preparation Example 5>

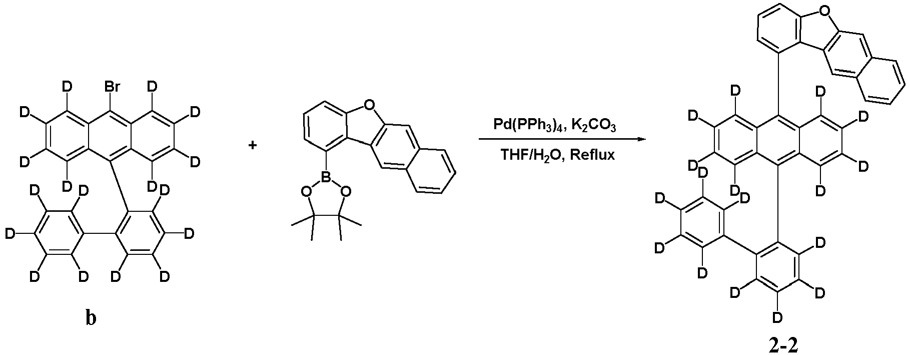

Compound b (6.50g, 15.26 mmol) and 4,4,5,5-tetramethyl-2-(naphtho[2,3-b]benzofuran-1-yl)-1,3,2-dioxaborolane (5.78 g, 16.78 mmol) were completely dissolved in 240 ml of tetrahydrofuran in a 500-ml round bottom flask under a nitrogen atmosphere, and then an aqueous 2 M potassium carbonate solution (120 ml) was added thereto, tetrakis-(triphenylphosphine)palladium (0.53 g, 0.46 mmol) was added thereto, and then the resulting mixture was heated and stirred for 3 hours. The temperature was lowered to room temperature, the aqueous layer was removed, and the residue was dried over anhydrous magnesium sulfate, and then concentrated under reduced pressure, and recrystallized with 340 ml of ethyl acetate to prepare Compound 2-2 (6.67 g, 78%).
MS[M+H]⁺= 564

### <Preparation Example 6>

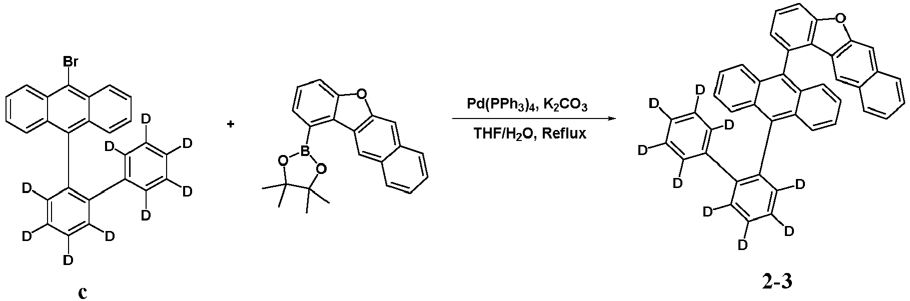

Compound c (6.50 g, 15.55 mmol) and 4,4,5,5-tetramethyl-2-(naphtho[2,3-b]benzofuran-1-yl)-1,3,2-dioxaborolane (5.89 g, 17.11 mmol) were completely dissolved in 220 ml of tetrahydrofuran in a 500-ml round bottom flask under a nitrogen atmosphere, and then an aqueous 2 M potassium carbonate solution (110ml) was added thereto, tetrakis-(triphenylphosphine)palladium (0.54 g, 0.47 mmol) was added thereto, and then the resulting mixture was heated and stirred for 5 hours. The temperature was lowered to room temperature, the aqueous layer was removed, and the residue was dried over anhydrous magnesium sulfate, and then concentrated under reduced pressure, and recrystallized with 250 ml of ethyl acetate to prepare Compound 2-3 (6.34 g, 73%).
MS[M+H]⁺= 556

### Comparative Example 1

A glass substrate thinly coated with indium tin oxide (ITO) to have a thickness of 1,000 Å was put into distilled water in which a detergent was dissolved, and ultrasonically washed. In this case, a product manufactured by the Fischer Co., was used as the detergent, and distilled water twice filtered using a filter manufactured by Millipore Co., was used as the distilled water. After the ITO was washed for 30 minutes, ultrasonic washing was repeated twice by using distilled water for 10 minutes. After the washing using distilled water was completed, ultrasonic washing was conducted by using isopropyl alcohol, acetone, and methanol solvents, and the resulting product was dried and then transported to a plasma washing machine. Furthermore, the substrate was cleaned by using oxygen plasma for 5 minutes, and then was transported to a vacuum deposition machine.

The compounds of the following Chemical Formula [HI-1] and the following Chemical Formula [HI-2] were thermally vacuum deposited to have a thickness of 100 Å at a ratio of 98 : 2 (molar ratio) on the transparent ITO electrode thus prepared, thereby forming a hole injection layer.

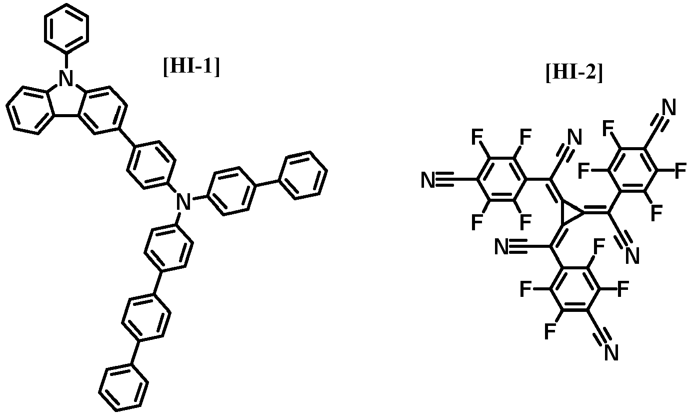

The following Compound [HT-1] (1,150 Å) as a material which transports holes was vacuum deposited on the hole injection layer, thereby forming a hole transport layer.

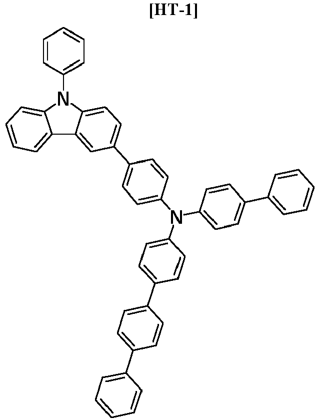

Subsequently, the following Compound [EB-1] (150 Å) was vacuum deposited to have a film thickness of 50 Å on the electron transport layer, thereby forming an electron blocking layer.

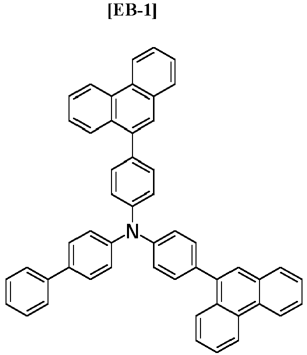

Subsequently, the following [BH-1] and [BD-1] were vacuum deposited at a weight ratio of 40:1 to have a film thickness of 200 Å on the electron blocking layer, thereby forming a light emitting layer.

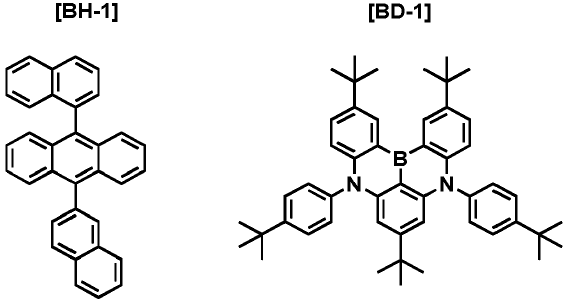

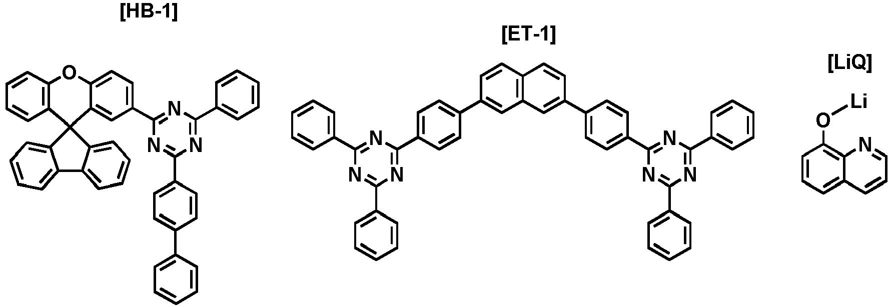

Compound [HB-1] was vacuum deposited to have a film thickness of 50 Å on the light emitting layer, thereby forming a hole blocking layer.

Subsequently, a compound [ET-1] and the compound lithium quinolate (LiQ) were vacuum deposited at a weight ratio of 1 : 1 on the hole blocking layer, thereby forming an electron transport and injection layer having a thickness of 300 Å.

Lithium fluoride (LiF) and aluminum were subsequently deposited to have a thickness of 12 Å and 2,000 Å, respectively, on the electron transport and injection layer, thereby forming a negative electrode.

In the aforementioned procedure, the deposition rate of the organic material was maintained at 0.4 to 0.7 Å/sec, the deposition rates of lithium fluoride and aluminum of the negative electrode were maintained at 0.3 Å/sec and at 2 Å/sec, respectively, and the degree of vacuum during the deposition was maintained at 2 × 10⁻⁷ to 5 × 10⁻⁶ torr, thereby manufacturing an organic light emitting device.

### Comparative Examples 2 to 12

Organic light emitting devices were manufactured in the same manner as in Comparative Example 1, except that the compounds described in the following Table 1 were used instead of [ET-1] and [BH-1] in Comparative Example 1.

### Experimental Examples 1-1 to 1-9

Organic light emitting devices were manufactured in the same manner as in Comparative Example 1, except that the compounds described in the following Table 1 were used instead of [ET-1] and [BH-1] in Comparative Example 1.

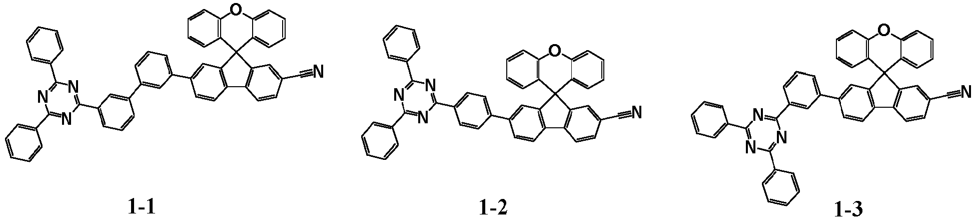

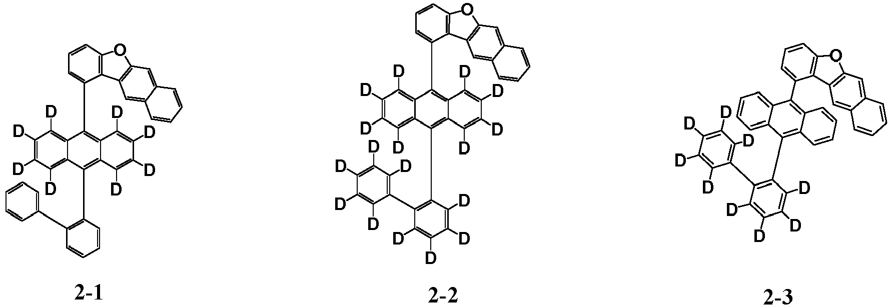

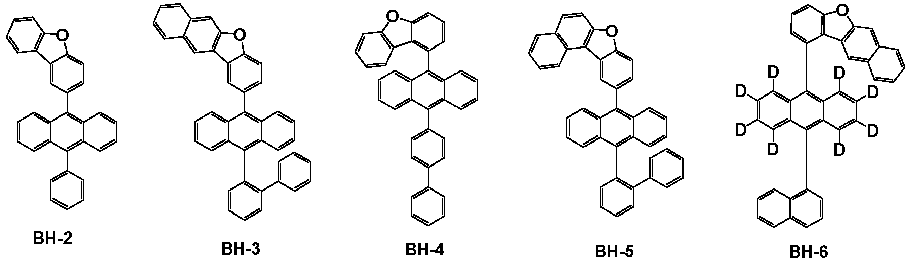

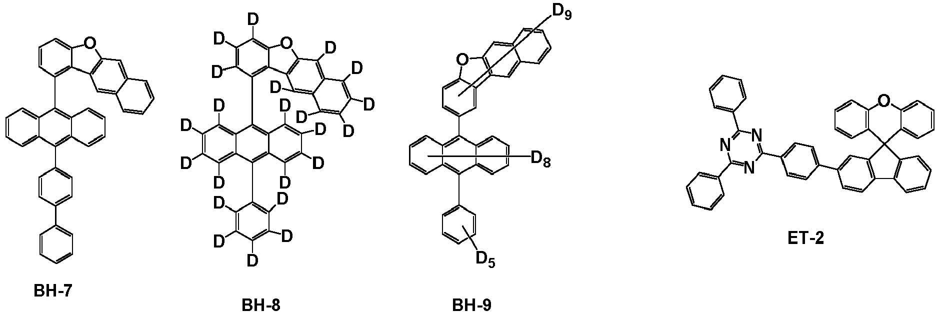

### Comparative Examples 13 to 15

Organic light emitting devices were manufactured in the same manner as in Comparative Example 1, except that Compounds 1-1, 1-2 and 1-3 were used instead of [ET-1].

### Comparative Examples 16 to 18

Organic light emitting devices were manufactured in the same manner as in Comparative Example 1, except that Compounds 2-1, 2-2 and 2-3 were used instead of [BH-1].

### Comparative Examples 19 to 21

Organic light emitting devices were manufactured in the same manner as in Comparative Example 1, except that Compounds 2-1, 2-2 and 2-3 were used instead of [BH-1] and [ET-2] was used instead of [ET-1].

### Comparative Examples 22 to 36

Organic light emitting devices were manufactured in the same manner as in Comparative Example 1, except that the compounds described in the following Table 1 were used instead of [ET-1] and [BH-1] in Comparative Example 1.

### Comparative Examples 37 to 45

Organic light emitting devices were manufactured in the same manner as in Comparative Example 1, except that Compounds 1-1, 1-2 and 1-3 were used instead of Compound [ET-1] in Comparative Example 1, and [BH-7] to [BH-9] were used instead of [BH-1].

When an electric current of 20 mA/cm² was applied to the organic light emitting devices manufactured in the Experimental Examples and the Comparative Examples, the driving voltage, the light emitting efficiency, and the color coordinate were measured from the manufactured organic light emitting devices at a current density of 20 mA/cm², and time (T95) taken for the luminance to become 95% of the initial luminance at a current density of 20 mA/cm² was measured. The results are shown in the following Table 1. T95 means the time taken for the luminance to be reduced to 95% of the initial luminance (1600 nit).

**[Table 1]**

| | Compound (Electron transport and injection layer) | Compound (Light emitting layer) | voltage (V @20mA /cm²) | efficiency (cd/A @20mA / cm²) | Color coordinate (x, Y) | T98 (hr) |
|---|---|---|---|---|---|---|
| Comparative Example 1 | ET-1 | BH-1 | 4.51 | 4.61 | (0.144, 0.046) | 241 |
| Comparative Example 2 | ET-1 | BH-2 | 4.41 | 4.66 | (0.145, 0.047) | 192 |
| Comparative Example 3 | ET-1 | BH-3 | 4.46 | 4.64 | (0.146, 0.045) | 213 |
| Comparative Example 4 | ET-1 | BH-4 | 4.48 | 4.68 | (0.145, 0.044) | 205 |
| Comparative Example 5 | ET-1 | BH-5 | 4.44 | 4.65 | (0.146, 0.046) | 209 |
| Comparative Example 6 | ET-1 | BH-6 | 4.50 | 4.71 | (0.144, 0.045) | 212 |
| Comparative Example 7 | ET-2 | BH-1 | 4.46 | 4.64 | (0.144, 0.046) | 210 |
| Comparative Example 8 | ET-2 | BH-2 | 4.36 | 4.69 | (0.145, 0.047) | 178 |
| Comparative Example 9 | ET-2 | BH-3 | 4.41 | 4.67 | (0.146, 0.045) | 195 |
| Comparative Example 10 | ET-2 | BH-4 | 4.43 | 4.71 | (0.145, 0.044) | 203 |
| Comparative Example 11 | ET-2 | BH-5 | 4.39 | 4.68 | (0.146, 0.046) | 199 |
| Comparative Example 12 | ET-2 | BH-6 | 4.45 | 4.74 | (0.144, 0.045) | 206 |
| Experimental Example 1-1 | 1-1 | 2-1 | 3.61 | 5.73 | (0.144, 0.046) | 374 |
| Experimental Example 1-2 | 1-1 | 2-2 | 3.65 | 5.71 | (0.145, 0.045) | 376 |
| Experimental Example 1-3 | 1-1 | 2-3 | 3.66 | 5.79 | (0.144, 0.047) | 343 |
| Experimental Example 1-4 | 1-2 | 2-1 | 3.73 | 5.67 | (0.145, 0.045) | 357 |
| Experimental Example 1-5 | 1-2 | 2-2 | 3.75 | 5.62 | (0.146, 0.046) | 352 |
| Experimental Example 1-6 | 1-2 | 2-3 | 3.77 | 5.62 | (0.146, 0.045) | 327 |
| Experimental Example 1-7 | 1-3 | 2-1 | 3.81 | 5.66 | (0.145, 0.046) | 368 |
| Experimental Example 1-8 | 1-3 | 2-2 | 3.83 | 5.64 | (0.145, 0.046) | 369 |
| Experimental Example 1-9 | 1-3 | 2-3 | 3.82 | 5.61 | (0.144, 0.045) | 335 |
| Comparative Example 13 | 1-1 | BH-1 | 4.13 | 5.33 | (0.144, 0.047) | 284 |
| Comparative Example 14 | 1-2 | BH-1 | 4.18 | 5.32 | (0.145, 0.045) | 263 |
| Comparative Example 15 | 1-3 | BH-1 | 4.22 | 5.35 | (0.146, 0.046) | 272 |
| Comparative Example 16 | ET-1 | 2-1 | 4.26 | 5.15 | (0.144, 0.047) | 309 |
| Comparative Example 17 | ET-1 | 2-2 | 4.28 | 5.21 | (0.145, 0.045) | 326 |
| Comparative Example 18 | ET-1 | 2-3 | 4.24 | 5.19 | (0.145, 0.046) | 304 |
| Comparative Example 19 | ET-2 | 2-1 | 4.21 | 5.18 | (0.146, 0.047) | 307 |
| Comparative Example 20 | ET-2 | 2-2 | 4.23 | 5.24 | (0.145, 0.045) | 285 |
| Comparative Example 21 | ET-2 | 2-3 | 4.19 | 5.22 | (0.145, 0.046) | 274 |
| Comparative Example 22 | 1-1 | BH-2 | 4.03 | 5.38 | (0.146, 0.047) | 237 |
| Comparative Example 23 | 1-2 | BH-2 | 4.08 | 5.37 | (0.145, 0.045) | 218 |
| Comparative Example 24 | 1-3 | BH-2 | 4.02 | 5.40 | (0.146, 0.046) | 224 |
| Comparative Example 25 | 1-1 | BH-3 | 4.08 | 5.36 | (0.145, 0.047) | 253 |
| Comparative Example 26 | 1-2 | BH-3 | 4.13 | 5.35 | (0.146, 0.045) | 232 |
| Comparative Example 27 | 1-3 | BH-3 | 4.17 | 5.38 | (0.146, 0.046) | 249 |
| Comparative Example 28 | 1-1 | BH-4 | 4.10 | 5.40 | (0.145, 0.047) | 246 |
| Comparative Example 29 | 1-2 | BH-4 | 4.15 | 5.39 | (0.145, 0.045) | 220 |
| Comparative Example 30 | 1-3 | BH-4 | 4.19 | 5.42 | (0.146, 0.046) | 235 |
| Comparative Example 31 | 1-1 | BH-5 | 4.132 | 5.37 | (0.146, 0.047) | 253 |
| Comparative Example 32 | 1-2 | BH-5 | 4.17 | 5.36 | (0.145, 0.045) | 232 |
| Comparative Example 33 | 1-3 | BH-5 | 4.21 | 5.39 | (0.146, 0.046) | 244 |
| Comparative Example 34 | 1-1 | BH-6 | 4.03 | 5.43 | (0.145, 0.047) | 264 |
| Comparative Example 35 | 1-2 | BH-6 | 4.08 | 5.44 | (0.145, 0.045) | 247 |
| Comparative Example 36 | 1-3 | BH-6 | 4.12 | 5.46 | (0.146, 0.046) | 253 |
| Comparative Example 37 | 1-1 | BH-7 | 4.11 | 5.35 | (0.145, 0.047) | 234 |
| Comparative Example 38 | 1-2 | BH-7 | 4.16 | 5.37 | (0.145, 0.045) | 223 |
| Comparative Example 39 | 1-3 | BH-7 | 4.20 | 5.38 | (0.146, 0.046) | 217 |
| Comparative Example 40 | 1-1 | BH-8 | 4.09 | 5.41 | (0.145, 0.047) | 252 |
| Comparative Example 41 | 1-2 | BH-8 | 4.13 | 5.47 | (0.145, 0.045) | 239 |
| Comparative Example 42 | 1-3 | BH-8 | 4.18 | 5.49 | (0.146, 0.046) | 245 |
| Comparative Example 43 | 1-1 | BH-9 | 4.10 | 5.32 | (0.145, 0.047) | 255 |
| Comparative Example 44 | 1-2 | BH-9 | 4.15 | 5.31 | (0.146, 0.045) | 234 |
| Comparative Example 45 | 1-3 | BH-9 | 4.19 | 5.30 | (0.146, 0.046) | 229 |

As shown in Table 1, in Experimental Examples 1-1 to 1-9, the compound of Chemical Formula 1 and the compound of Chemical Formula 2 are used as a material for the electron transport and injection layer, and the light emitting layer, respectively, and Experimental Examples 1-1 to 1-9 show the characteristics of the device to which the compounds of Chemical Formula 1 and Chemical Formula 2 are applied together.

Comparative Examples 1 to 12 show device characteristics when ET-1 or ET-2 is used as the electron transport and injection layer, and any one of BH-1 to BH-6 is used as the light emitting layer.

In Comparative Examples 13 to 36, the compound of Chemical Formula 1 is used instead of ET-1 or ET-2, or compound of Chemical Formula 2 is used instead of any one of BH-1 to BH-6, and Comparative Examples 13 to 36 show the characteristics of the device in which compounds of Chemical Formula 1 and Chemical Formula 2 are separately used.

Comparative Examples 37 to 45 show device characteristics when BH-7 to BH-10 are used instead of the compound of Chemical Formula 2.

Thus, it can be confirmed that compared to the Comparative Examples, the organic light emitting devices of the Experimental Examples basically show the characteristics of low voltage, high efficiency, and long service life, and in particular, the compounds of Chemical Formula 1 have the characteristics of high efficiency and the compounds of Chemical Formula 2 have the characteristics of long service life.

Specifically, when Experimental Examples 1-1 to 1-9 are compared with Comparative Examples 16 to 21, Experimental Examples 1-1 to 1-9 in which the compound of Chemical Formula 1 and the compound of Chemical Formula 2 are used showed the results in which the efficiency is increased by up to about 12% compared to Comparative Examples 16 to 21 in which the compound of Chemical Formula 1 is not used.

In addition, when Experimental Examples 1-1 to 1-9 are compared with Comparative Examples 13 to 15 and 22 to 36, Experimental Examples 1-1 to 1-9 in which the compound of Chemical Formula 1 and the compound of Chemical Formula 2 are used showed the results in which the service life is increased by up to about 72% compared to Comparative Examples 13 to 15 and 22 to 36 in which the compound of Chemical Formula 2 is not used.

Comparative Examples 19 to 21 are cases where a compound (ET-2) containing no cyano group was used. When Experimental Examples 1-1 to 1-9 are compared with Comparative Examples 19 to 21, it can be confirmed that Experimental Examples 1-1 to 1-9 using the compound of Chemical Formula 1 including a cyano group have a lower driving voltage, a higher light emitting efficiency, and a longer service life than Comparative Examples 19 to 21.

Comparative Examples 22 to 24 are the cases of using a compound (BH-2) in which a phenyl group and dibenzofuran are linked into an anthracene core. When Experimental Examples 1-1 to 1-9 are compared with Comparative Examples 22 to 24, it can be confirmed that Experimental Examples 1-1 to 1-9 using the compound of Chemical Formula 2, in which naphthobenzofuran and a biphenyl group are linked into an anthracene core, have a lower driving voltage, a higher light emitting efficiency, and a longer service life than Comparative Examples 22 to 24.

Comparative Examples 25 to 27 and 43 to 45 are the cases of using compounds (BH-3 and BH-9) in which the linking position of naphthobenzofuran is different from that of Chemical Formula 2 of the present application. When Experimental Examples 1-1 to 1-9 are compared with Comparative Examples 25 to 27 and 43 to 45, it can be confirmed that Experimental Examples 1-1 to 1-9 using the compound of Chemical Formula 2 of the present application have a lower driving voltage, a higher light emitting efficiency, and a longer service life than Comparative Examples 25 to 27 and 43 to 45 using compounds (BH-3 and BH-9) in which the linking position of naphthobenzofuran is different from that of Chemical Formula 2 of the present application.

Comparative Examples 28 to 30 are the cases of using a compound (BH-4) in which a biphenyl group and dibenzofuran are linked into an anthracene core. When Experimental Examples 1-1 to 1-9 are compared with Comparative Examples 28 to 30, it can be confirmed that Experimental Examples 1-1 to 1-9 using the compound of Chemical Formula 2, in which naphthobenzofuran is linked into an anthracene core, have a lower driving voltage, a higher light emitting efficiency, and a longer service life than Comparative Examples 28 to 30.

Comparative Examples 31 to 34 are the cases of using a compound (BH-5) in which the fusion position of benzene in naphthobenzofuran is different from that of Chemical Formula 2 of the present application. When Experimental Examples 1-1 to 1-9 are compared with Comparative Examples 31 to 34, it can be confirmed that Experimental Examples 1-1 to 1-9 using the compound of Chemical Formula 2 of the present application have a lower driving voltage, a higher light emitting efficiency, and a longer service life than Comparative Examples 31 to 34 using a compound (BH-5) in which the fusion position of benzene in naphthobenzofuran is different from that of Chemical Formula 2 of the present application.

Comparative Examples 34 to 36 are the cases of using a compound (BH-6) in which a naphthyl group instead of a biphenyl group is linked into an anthracene core. When Experimental Examples 1-1 to 1-9 are compared with Comparative Examples 34 to 36, it can be confirmed that Experimental Examples 1-1 to 1-9 using the compound of Chemical Formula 2, in which a biphenyl group is linked into an anthracene core, have a lower driving voltage, a higher light emitting efficiency, and a longer service life than Comparative Examples 34 to 36.

Comparative Examples 37 to 39 are the cases of using a compound (BH-7) in which a biphenyl group including a para-phenyl group instead of a biphenyl group including an ortho-phenyl group is linked into an anthracene core. When Experimental Examples 1-1 to 1-9 are compared with Comparative Examples 37 to 39, it can be confirmed that Experimental Examples 1-1 to 1-9 using the compound of Chemical Formula 2, in which a biphenyl group including an ortho-phenyl group is linked into an anthracene core, have a lower driving voltage, a higher light emitting efficiency, and a longer service life than Comparative Examples 37 to 39.

Comparative Examples 40 to 42 are the cases of using a compound (BH-8) in which a phenyl group substituted with deuterium instead of a biphenyl group is linked into an anthracene core. When Experimental Examples 1-1 to 1-9 are compared with Comparative Examples 40 to 42, it can be confirmed that Experimental Examples 1-1 to 1-9 using the compound of Chemical Formula 2, in which a biphenyl group is linked into an anthracene core, have a lower driving voltage, a higher light emitting efficiency, and a longer service life than Comparative Examples 40 to 42.

Through this, it can be confirmed that when the compound of Chemical Formula 1 of the present invention is used as a material for the electron transport and injection layer, and the compound of Chemical Formula 2 of the present invention is used in combination as a material for the light emitting layer, it is possible to have high efficiency characteristics while maintaining the long service life characteristics of the organic light emitting device.

Although the preferred exemplary embodiments (a combination experiment of an electron transport and injection layer and a light emitting layer) of the present invention have been described above, the present invention is not limited thereto, and various modifications can be made and carried out within the scope of the claims and the detailed description of the invention, and also fall within the scope of the invention.

### [Explanation of Reference Numerals and Symbols]

- 1:: Substrate
- 2:: Anode
- 3:: Hole injection layer
- 4:: Hole transport layer
- 5:: Electron blocking layer
- 6:: Light emitting layer
- 7:: Hole blocking layer
- 8:: Electron transport layer
- 9:: Electron injection layer
- 10:: Cathode
- 11:: Electron transport and injection layer
- 21:: First organic material layer
- 22:: Second organic material layer

## Claims

1. An organic light emitting device, comprising:
an anode;
a cathode; and
a first organic material layer and a second organic material layer provided between the anode and the cathode,
wherein the first organic material layer comprises a compound of the following Chemical Formula 1, and
the second organic material layer comprises a compound of the following Chemical Formula 2: 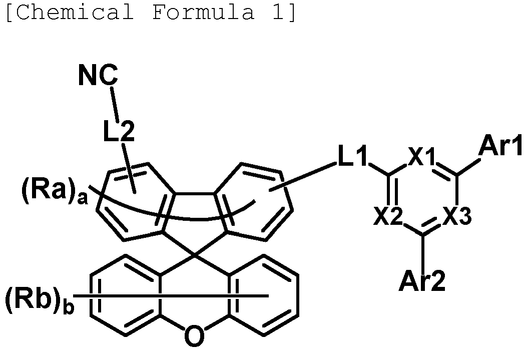
wherein in Chemical Formula 1:
Ar1 and Ar2 are the same as or different from each other, and are each independently hydrogen, deuterium, or a substituted or unsubstituted aryl group;
L1 and L2 are the same as or different from each other, and are each independently a direct bond or a substituted or unsubstituted arylene group;
X1 to X3 are the same as or different from each other, and are each independently N or CR;
at least one of X1 to X3 is N;
Ra, Rb and R are the same as or different from each other, and are each independently hydrogen, deuterium, a substituted or unsubstituted alkyl group, or a substituted or unsubstituted aryl group;
a is an integer from 0 to 6, and when a is 2 or higher, two or more Ras are the same as or different from each other; and
b is an integer from 0 to 8, and when b is 2 or higher, two or more Rbs are the same as or different from each other; 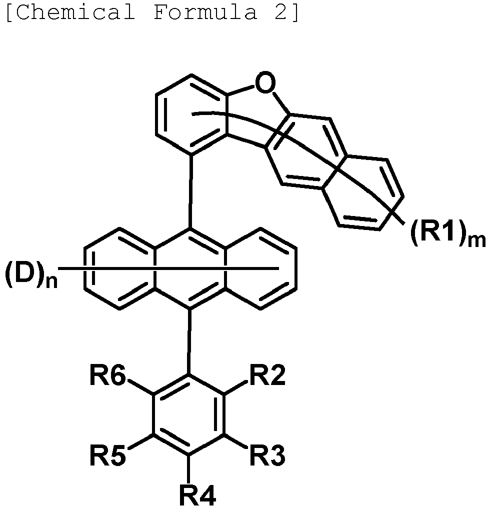
wherein in Chemical Formula 2:
R1 is hydrogen, deuterium, a substituted or unsubstituted alkyl group, or a substituted or unsubstituted aryl group;
m is an integer from 0 to 9, and when m is 2 or higher, two or more R1s are the same as or different from each other;
D is deuterium, and n is an integer from 0 to 8;
R2 to R6 are the same as or different from each other, and are each independently hydrogen, deuterium, a substituted or unsubstituted alkyl group, or the following Chemical Formula A;
at least one of R2 and R6 is the following Chemical Formula A: 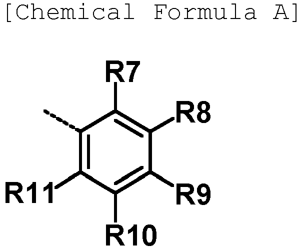
wherein in Chemical Formula A:
R7 to R11 are the same as or different from each other, and are each independently hydrogen, deuterium, a substituted or unsubstituted alkyl group, or a substituted or unsubstituted aryl group, or adjacent substituents are bonded to each other to form a substituted or unsubstituted ring; and
a dotted line (---) is a moiety linked to Chemical Formula 2.

2. The organic light emitting device of claim 1, wherein Chemical Formula 1 is any one of the following Chemical Formulae 1-1 to 1-4: 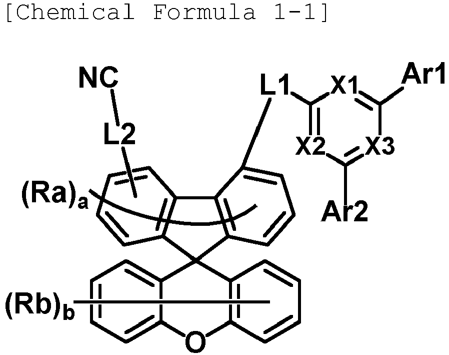 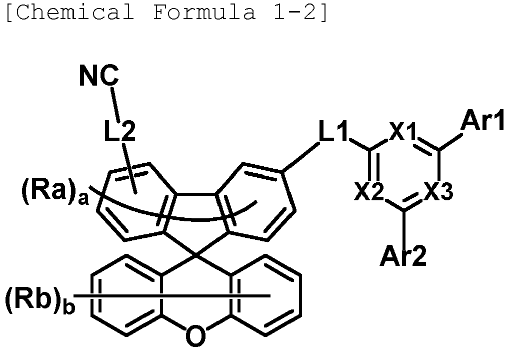 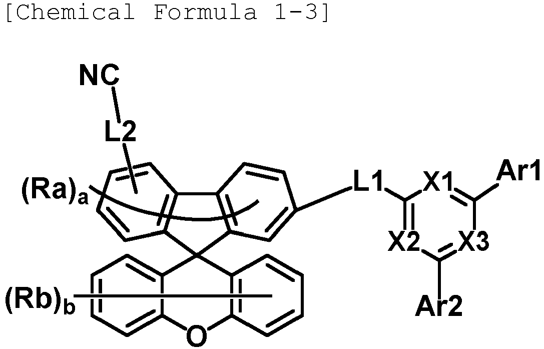 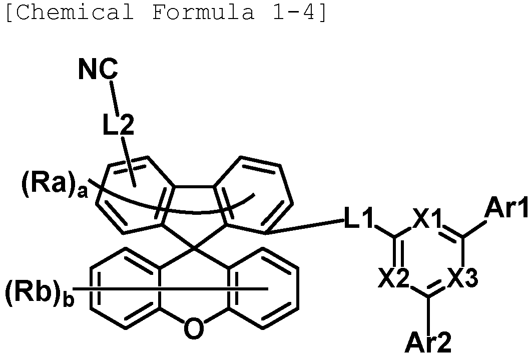 wherein in Chemical Formulae 1-1 to 1-4:
the definitions of Ar1, Ar2, L1, L2, X1 to X3, Ra, Rb, a and b are the same as the definitions in Chemical Formula 1.

3. The organic light emitting device of claim 1, wherein Chemical Formula 1 is any one of the following Chemical Formulae 1-A to 1-D: 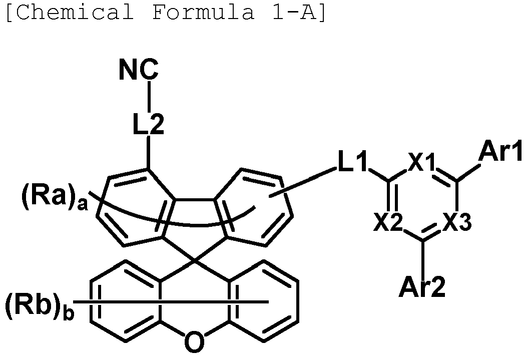 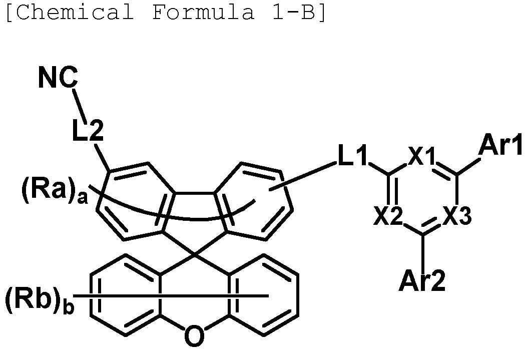 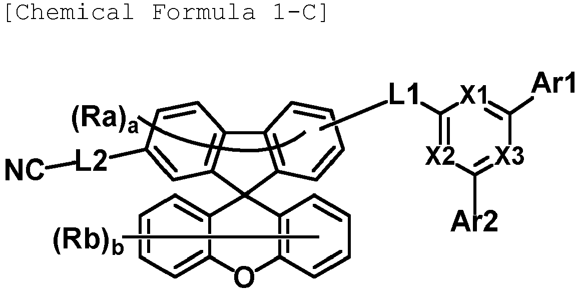 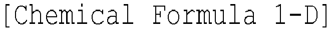 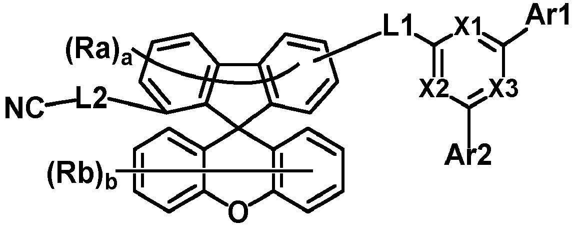
wherein in Chemical Formulae 1-A to 1-D:
the definitions of Ar1, Ar2, L1, L2, X1 to X3, Ra, Rb, a and b are the same as the definitions in Chemical Formula 1.

4. The organic light emitting device of claim 1, wherein Chemical Formula 1 is the following Chemical Formula 1-1-1: 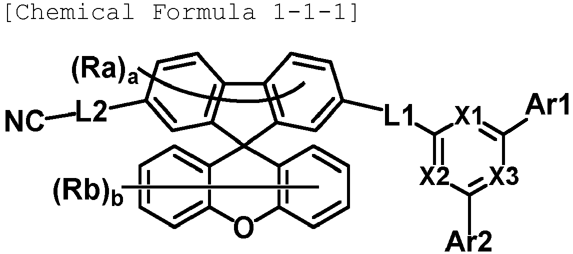
wherein in Chemical Formula 1-1-1:
the definitions of Ar1, Ar2, L1, L2, X1 to X3, Ra, Rb, a and b are the same as the definitions in Chemical Formula 1.

5. The organic light emitting device of claim 1, wherein Chemical Formula 2 is the following Chemical Formula 2-1: 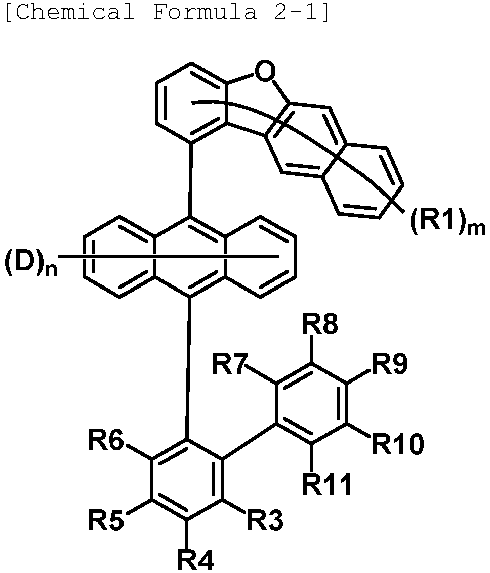
wherein in Chemical Formula 2-1:
the definitions of R1, m, D, n and R3 to R11 are the same as the definitions in Chemical Formula 2.

6. The organic light emitting device of claim 1, wherein Ar1 and Ar2 are the same as or different from each other, and are each independently a substituted or unsubstituted aryl group having 6 to 30 carbon atoms.

7. The organic light emitting device of claim 1, wherein L1 and L2 are the same as or different from each other, and are each independently a direct bond, a substituted or unsubstituted phenylene group, or a substituted or unsubstituted biphenylene group.

8. The organic light emitting device of claim 1, wherein X1 to X3 are N.

9. The organic light emitting device of claim 1, wherein the others of R1 to R11, which are not Chemical Formula A, are the same as or different from each other, and are each independently hydrogen or deuterium.

10. The organic light emitting device of claim 1, wherein the compound of Chemical Formula 2 comprises at least one deuterium.

11. The organic light emitting device of claim 1, wherein the compound of Chemical Formula 1 is any one of the following compounds:

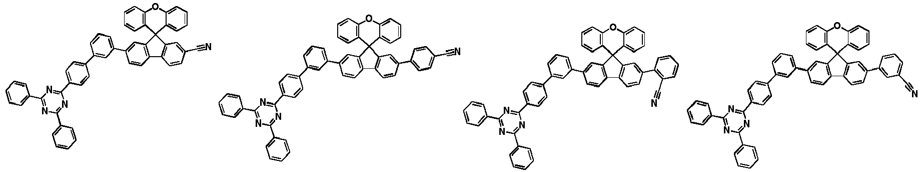

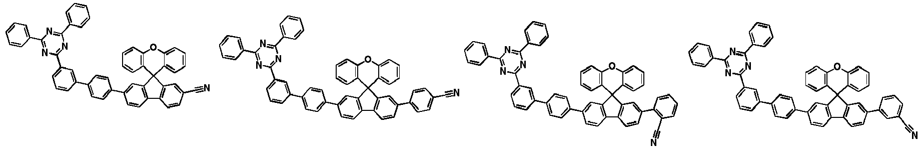

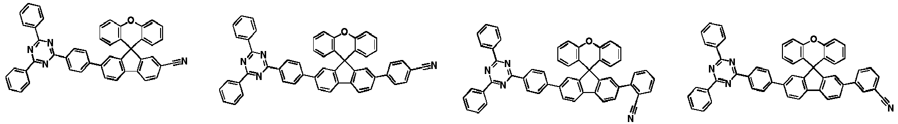

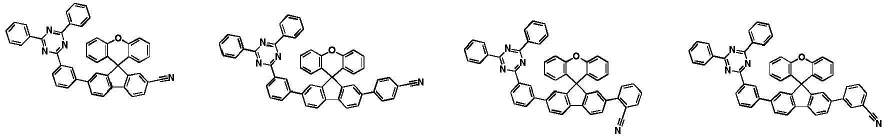

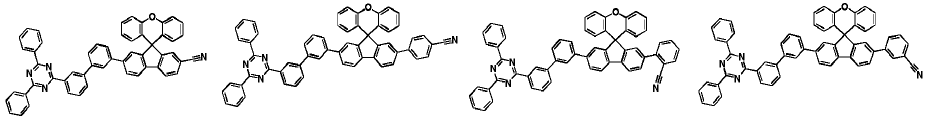

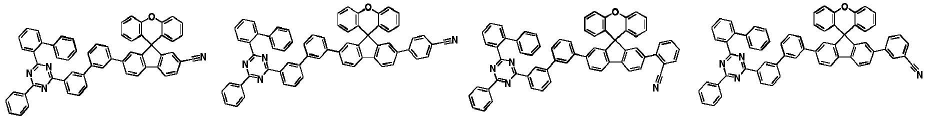

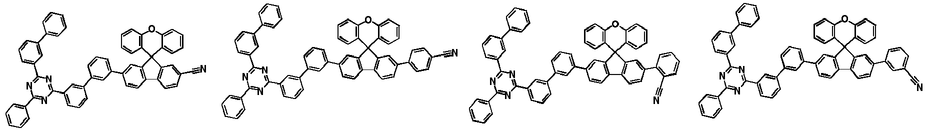

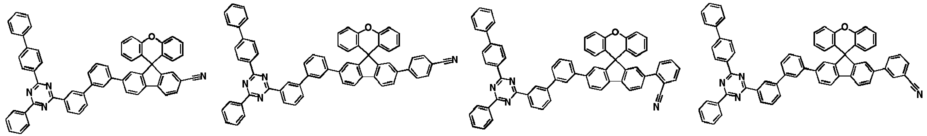

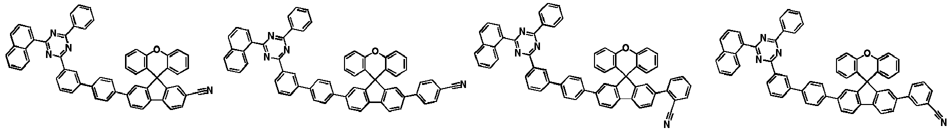

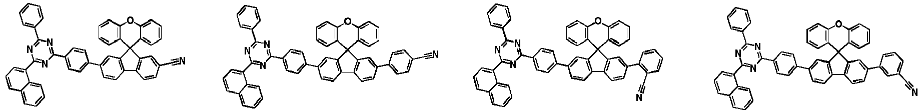

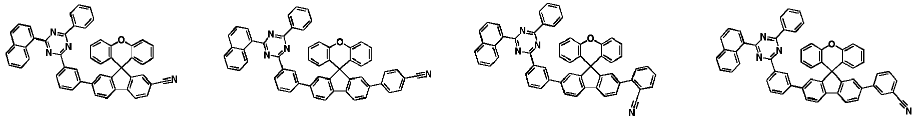

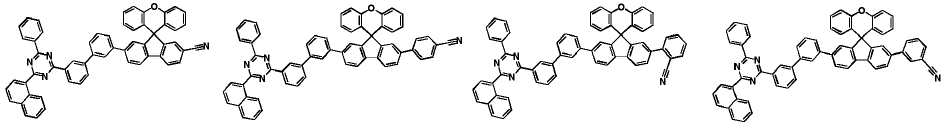

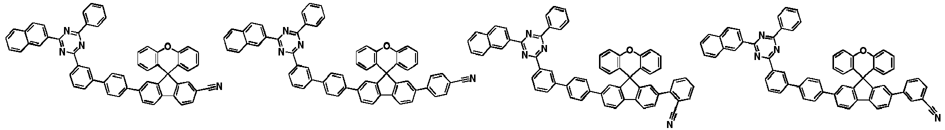

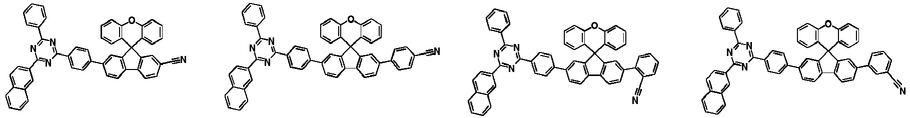

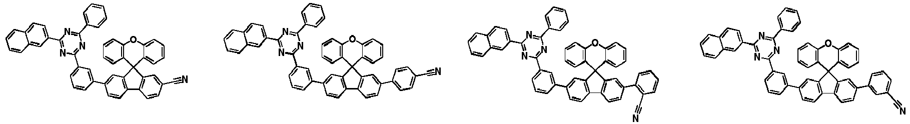

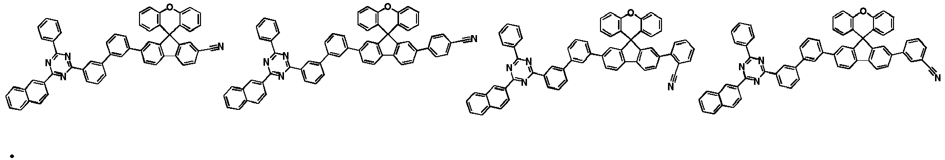

12. The organic light emitting device of claim 1, wherein the compound of Chemical Formula 2 is any one of the following compounds:

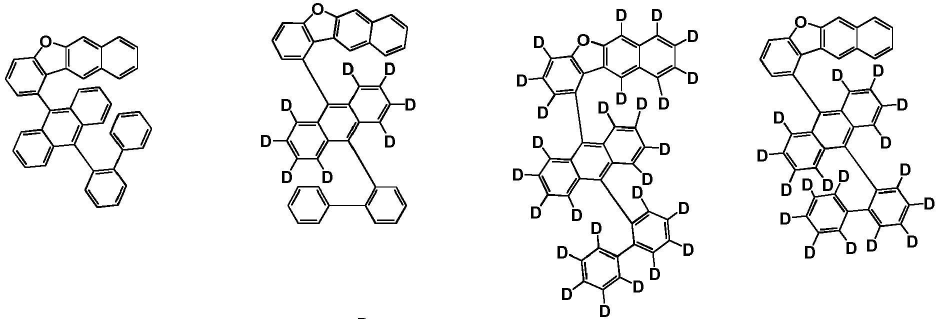

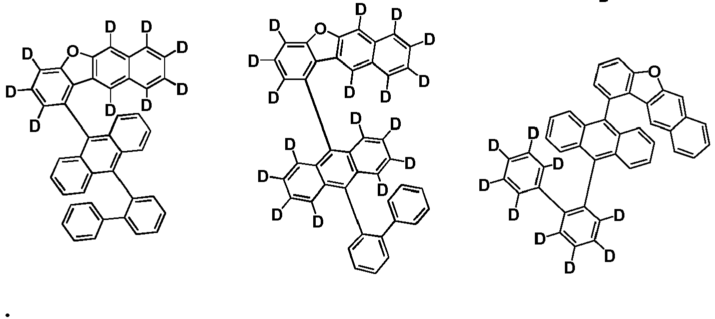

13. The organic light emitting device of claim 1, wherein the first organic material layer is located between the second organic material layer and the cathode.

14. The organic light emitting device of claim 1, wherein the first organic material layer is an electron transport layer, an electron injection layer, or an electron transport and injection layer.

15. The method of claim 13 or 14, wherein a hole blocking layer is located between the first organic material layer and the second organic material layer.

16. The organic light emitting device of claim 1, wherein the second organic material layer is a light emitting layer.

17. The organic light emitting device of claim 16, wherein the light emitting layer comprises the compound of Chemical Formula 2 as a host and further comprises a dopant.

18. The organic light emitting device of claim 1, wherein an organic material layer having one or more layers is further provided between the anode and the cathode, and the organic material layer comprises one or more layers of a hole transport layer, a hole injection layer, a hole transport and injection layer, an electron blocking layer, a light emitting layer, an electron transport layer, an electron injection layer, an electron transport and injection layer, and a hole blocking layer.
